(19) Europäisches Patentamt
European Patent Office
Office européen des brevets

(11) **EP 4 258 321 A1**

(12) ## EUROPÄISCHE PATENTANMELDUNG

(43) Veröffentlichungstag:
**11.10.2023  Patentblatt 2023/41**

(21) Anmeldenummer: **23166989.6**

(22) Anmeldetag: **06.04.2023**

(51) Internationale Patentklassifikation (IPC):
***H01J 37/32*** *(2006.01)*    ***B01J 19/00*** *(2006.01)*

(52) Gemeinsame Patentklassifikation (CPC):
**H01J 37/32192; B01J 19/0053**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(30) Priorität: **07.04.2022  DE 102022108482**

(71) Anmelder: **Karlsruher Institut für Technologie**
**76131 Karlsruhe (DE)**

(72) Erfinder:
- **DITTMEYER, Roland**
  **76133 Karlsruhe (DE)**
- **SOLDATOV, Sergey**
  **76344 Eggenstein-Leopoldshafen (DE)**
- **NAVARRETE MUNOZ, Alexander**
  **76185 Karlsruhe (DE)**

(74) Vertreter: **Rupprecht, Kay**
**Meissner Bolte Patentanwälte Rechtsanwälte Partnerschaft mbB**
**Kaiserswerther Straße 183**
**40474 Düsseldorf (DE)**

(54) **VERFAHREN UND SYSTEME FÜR DIE SYNTHESE VON CHEMISCHEN ENERGIETRÄGERN UNTER EINSATZ VON INTERMITTIERENDEN ENERGIEQUELLEN**

(57)    Die vorliegende Erfindung betrifft Systeme, Vorrichtungen und Verfahren zur Energiespeicherung, zum Lastausgleich oder zur Herstellung von Chemikalien und Brennstoffen sowie zur Umwandlung, insbesondere unter Verwendung von intermittierendem und erneuerbarem Strom, und unter Einsatz von thermisch moduliertem Plasma.

Fig. 2a

**Beschreibung**

Alle in der vorliegenden Anmeldung zitierten Dokumente sind durch Verweis vollumfänglich in die vorliegende Offenbarung einbezogen (= incorporated by reference in their entirety).

Die vorliegende Erfindung betrifft Systeme, Vorrichtungen und Verfahren zur Energiespeicherung, zum Lastausgleich oder zur Herstellung von Chemikalien und Brennstoffen sowie zur Umwandlung, insbesondere unter Verwendung von intermittierendem und erneuerbarem Strom, und unter Einsatz von thermisch moduliertem Plasma.

Stand der Technik:

Die zunehmende Mitverwendung von erneuerbaren Energien ist notwendig, um die Auswirkungen auf die Klimawandlung in unserer Gesellschaft zu verringern. In Übereinstimmung mit IEA ist die Ausdehnung der Verwendung von Elektrizität auf weitere Teile der Wirtschaft der größte Beitrag bei der Erreichung von netto-Zero-Emissionen. Jedoch erzeugt die Zunahme an erneuerbaren Energien Instabilitäten im Stromnetz. Verbunden damit ist die dezentralisierte Erzeugung von erneuerbaren Energien ein potenzieller Weg zur Reduzierung der Last im elektrischen Stromnetz identifiziert und um die Auswirkungen auf die Umwelt zu verringern. Daher sind verlässliche Technologien zur Energiespeicherung notwendig.

Erneuerbare Energien sind nur intermittierend verfügbar und oft lediglich während einiger Stunden oder Minuten. Dies kann zu einem Problem für konventionelle Technologien werden, die auf eine konstante Versorgung mit Energie angewiesen bzw. daraufhin zugeschnitten sind. Zusätzlich gibt es geographische Einschränkungen. Ein Beispiel dieser Einschränkung ist Wasserpumpenspeicherung, die eine Effizienz von größer als 80% aufweisen kann, allerdings in der Regel nicht dort verfügbar ist, wo die erneuerbaren Energiequellen sind. Dies führt zu einer Erweiterung des Stromnetzes und demzufolge größeren Auswirkungen auf die Umwelt.

Zusätzlich werden Dienste, die auf der Verwendung von fossilen Brennstoffen beruhen, wie der Flugverkehr, der Ferntransportverkehr, das Verschiffen, die Herstellung von strategischen Materialien wie Stahl oder Chemikalien weiterhin herausfordernd sein. Demgemäß sollten Brennstoffe und Chemikalien zur Aufrechterhaltung dieser Dienste aus erneuerbaren Energien stammen und reichlich verfügbare Chemikalien wie nicht-fossiles $CO_2$, (atmosphärisches) Wasser und Stickstoff und dergleichen stammen. Dennoch ist die reichliche Verfügbarkeit dieser Chemikalien deren chemischer Stabilität geschuldet, was bedeutet, dass entweder hohe Energiemengen (typischerweise in der Form von Temperatur oder Druck) oder Chemikalien mit hohem Energieinhalt (zum Beispiel Wasserstoff) für deren Umwandlung notwendig sind. Aktuelle Technologien, um diese Synthesen zu adressieren basieren hauptsächlich auf thermischen oder elektrischen Routen. Diese Technologien weisen jedoch einige Limitierungen auf:

- Thermische Trägheit. Konventionelle thermische Technologien erfordern typischerweise Stunden oder Tage für stabile Fahrweise.
- Kurzzeitstabilität von elektrochemischen Systemen, zusammen mit der Mitverwendung von Materialien wie Platin, bedingen hohe Kosten. Elektrochemische Systeme erfordern zusätzlich zumindest Minuten, um stabile Fahrweise zu erreichen. Die chemische Umwandlung mit Plasma hat verschiedene Vorteile:
- Plasmabasierte Reaktionen können umgehend an und ausgeschaltet werden, was die Verwendung von intermittierender Elektrizität erlaubt.
- Die Reaktionen können im ganzen Volumen der Reaktoren ablaufen (hauptsächlich Plasmaentladung), was mit der nur an Oberflächen erfolgenden Aktivierung bei anderen Technologien kontrastiert.
- Geringe Investment- und Betriebskosten (Personal).

Dementsprechend verwenden jüngere Initiativen für die Integration von erneuerbaren Energien in chemischen Verfahren Mikrowellenplasmas für $CO_2$-Aktivierungen. Ein Beispiel ist das europäische Projekt Kerogreen, worin die Herstellung von Flugzeugtreibstoffen, basierend auf erneuerbarer Elektrizität erforscht wird, oder das Kopernikus Satellitenprojekt PiCK (Plasma-induzierte $CO_2$ Konversion). Beide Initiativen basieren auf der Verwendung von Membranen zusammen mit Plasmas um den produzierten Sauerstoff während der Spaltung des $CO_2$ abzutrennen.

Dennoch sind die bis dato effizientesten Plasma-Umwandlungen (basierend auf warmem Plasma) auf die Verwendung von Vakuum limitiert, was für die breite Anwendung der Technologie nicht förderlich ist.

Auf der anderen Seite ergeben sich einige Nachteile, wenn atmosphärischer Druck verwendet wird, zum Beispiel verringern Rekombination und Überhitzung die Performance der Umwandlung.

Im Wesentlichen sind die Beschränkungen des Standes der Technik die folgenden:

- Keine kompakten Systeme und große thermische Trägheit.
- Kaum basierend auf Elektrizität basierenden Quellen.
- Nicht effizient.

Zum Beispiel braucht das in der US 2020/0255290 A1 beschriebene Verfahren mehrere Stunden nur um die Reaktionstemperatur zu erreichen. Auch bei dem in US 9,580,326 B1 beschriebenen Verfahren ist das Problem, dass die Erhitzung mit Öfen eine lange Zeit erfordert, um die nötige Temperatur zu erreichen. Die Umsetzung von stabilen Molekülen wie COz ist mit dem in US 2016/0194766 A1 beschriebenen Verfahren und den darin verwendeten Plasmen nicht effizient. WO 2020/174118 A1 offenbart zum Teil die Herausforderung von intermittierende Energiespeicherung, ist jedoch für sehr stabile Moleküle wie COz oder Stickstoff nicht geeignet. Zudem ist der hierin beschriebene Prozess langsamer, erfordert mehrere Minuten und ist nur für kleinere Gasmengen geeignet. In der US 2015/0030529 A1 wird ein langsamer Erwärmungsprozess, gesteuert durch Vakuum-Zyklen, beschrieben. Zudem sind die Investmentkosten sehr hoch und die möglichen geografischen Orte beschränkt. Auch in US 9,399,575 B2 wird ein langsamer Erwärmungsprozess beschrieben, der mehrerer Stunden zur Erreichung von stabilen Betriebsbedingungen benötigt. Hier sind ebenfalls die Investitionskosten sehr hoch und mögliche geografische Lokationen beschränkt. Als weiterer Stand der Technik könnte US 2015/0215515 A1 genannt werden, die Plasma und Mikrowellen als exklusive Alternativen der Energiezufuhr für Cracking-Reaktionen offenbart.

Insofern besteht im Hinblick auf die Systeme des Standes der Technik noch Verbesserungsbedarf.

Aufgabe:

Aufgabe der vorliegenden Erfindung war es mithin Vorrichtungen, Verfahren und Verwendungen zur Verfügung zu stellen, welche die Nachteile des Standes der Technik nicht mehr, oder zumindest nur erheblich reduziert, aufweisen.

Weitere Aufgabenstellungen ergeben sich für den Fachmann aus der nachfolgenden Beschreibung.

Lösung:

Gelöst werden diese und andere Aufgaben im Rahmen der vorliegenden Erfindung durch die Gegenstände der unabhängigen Ansprüche.

Bevorzugte Ausgestaltungen ergeben sich aus den abhängigen Ansprüchen sowie der nachfolgenden Beschreibung.

Im Rahmen der vorliegenden Erfindung sind alle Mengenangaben, sofern nicht anders angegeben, als Gewichtsangaben zu verstehen.

Im Rahmen der vorliegenden Erfindung bedeutet der Begriff "Umgebungstemperatur" eine Temperatur von 20°C. Temperaturangaben sind, soweit nicht anders angegeben, in Grad Celsius (°C).

Sofern nichts Anderes angegeben wird, werden die angeführten Reaktionen bzw. Verfahrensschritte bei Umgebungsdruck (=Normaldruck/Atmosphärendruck), d.h. bei 101,325 kPa, durchgeführt (manchmal wird dies auch vereinfachend als 1 atm angeführt, wenn es auf den genauen Druck nicht ankommt).

Druckangaben im Rahmen der vorliegenden Erfindung, solange nichts Anderes angegeben ist, bedeuten absolute Druckangaben, zum Beispiel: x bar bedeutet x bar absolut ($bar_a$) und nicht x bar gauge.

Im Rahmen der vorliegenden Erfindung schließt der Begriff «umfassen» jeweils auch «bestehend aus» ein; das heißt eine entsprechende Liste kann neben den explizit genannten Elementen auch weitere Elemente enthalten (= umfassen), oder sie kann genau diese Elemente enthalten (=bestehen aus) (wobei unwesentliche Elemente wie Schrauben, Markierungen etc. nicht berücksichtig sind).

Im Rahmen der vorliegenden Erfindung bedeutet der Ausdruck "und/oder" dass beide in dem Zusammenhang genannten Elemente jeweils einzeln als auch die Kombination der in dem Zusammenhang genannten Elemente umfasst ist.

Im Rahmen der vorliegenden Erfindung wird unter "Plasma" ein Gas oder eine Gasmischung enthaltend aktive Spezies wie Elektronen, Ionen, Radikale, angeregte Atome und Moleküle zusammen mit neutralen Molekülen verstanden.

Chemisches Looping (CL) wird im Rahmen der vorliegenden Erfindung verstanden als ein Verfahren, das mittels Intermediaten (oder Sauerstoffüberträgern) zur Förderung einer Redoxreaktion oder Gasseparation abläuft. Ein CL-Verfahren besteht aus mindestens zwei oder mehr Reduktions- und Oxidations- (Redox)-Schritten, die eine Redoxschleife (oder Redoxzyklus) bilden. In zwei Redoxschritten (einer Schleife) wäre das Verfahren:

Schritt 1:     Oxidans + M → reduziertes Produkt + MO

Schritt 2:     Reduktans + MO -> oxidiertes Produkt + M,

worin M der reduzierte Sauerstoffüberträger ist und MO der oxidierte Sauerstoffüberträger. Auf diese Art und Weise kann eine Reaktion in Sub-Reaktionen aufgeteilt werden, die an unterschiedlichen Orten (oder Zeitpunkten) stattfinden, was die in-situ-Trennung der erhaltenen Produkte ermöglicht. Es gibt dabei verschiedene Arten von chemischen Schleifenprozessen, zum Beispiel: Chemische Schleifenredoxreaktionen, wobei der Reduktionsschritt unter Verwendung eines chemischen Energieträgers als Reduktans durchgeführt wird; thermochemische Schleifenredoxreaktionen, wobei der Reduktionsschritt thermisch aktiviert ist; chemische Schleifenreaktion mit Kohlendioxid.

Es sei darauf hingewiesen, dass der in der Beschreibung der vorliegenden Erfindung erwähnte Sauerstoffüberträger eine spezielle Ausführungsform eines Feststoffs, der als Überträger entweder für Sauerstoff, Stickstoff, Wasserstoff oder Kohlenstoffdioxid fungiert, ist und in der Regel durch die Formulierungen "Feststoff-Überträger bzw. Feststoff, der als Überträger entweder für Sauerstoff, Stickstoff, Wasserstoff oder Kohlenstoffdioxid fungiert" ersetzt werden kann, sofern nicht eine spezielle Umsetzung basierend auf Sauerstoff enthaltenden Molekülen beschrieben ist (und umgekehrt). Er ist also in der Regel als einfachere Formulierung bzw. Platzhalter zu verstehen. Ein einfacher ebenfalls gelegentlich verwendeter Begriff, der im Rahmen der vorliegenden Beschreibung, je nach Zusammenhang, das Eine oder das Andere oder beides bedeuten kann, ist der Begriff "Träger".

Ein Gegenstand der vorliegenden Erfindung betrifft eine neue Art von Schleifenredoxreaktion basierend auf Plasma.

Ein weiterer Gegenstand der vorliegenden Erfindung bezieht sich auf Systeme, Vorrichtungen und Verfahren zur Energiespeicherung, Lastausgleich oder der Herstellung von Chemikalien und Brennstoffen sowie deren Umwandlung. Unter anderem bezieht sich die Erfindung auf die Herstellung von Verbindungen wie beispielsweise auf (aber nicht limitiert auf) Ammoniak, Kohlenmonoxid, Synthesegas oder Olefinen, insbesondere unter der Verwendung von intermittierender, überschüssiger oder billiger Elektrizität, insbesondere Strom aus erneuerbaren Energien über die Aktivierung zweier verschiedener Arten von Rohmaterialien:

1. Stabile, reichlich verfügbare Moleküle wie Wasser, Stickstoff oder Kohlendioxid.
2. Reaktive Moleküle wie Methan, Kohlenwasserstoffe, Alkohole, Biomasse oder Brennstoffe. Höchst bevorzugt unter Verwendung der erfindungsgemäßen Vorrichtungen und/oder der erfindungsgemäßen Verfahren.

Die vorliegende Erfindung adressiert die oben genannten Probleme des Standes der Technik. Die neuen Verfahren der vorliegenden Erfindung machen es zum ersten Mal möglich, dass die effiziente Synthese (Tabelle 2) von chemischen Energieträgern, auf einer Zeitskala von Sekunden unter Verwendung von warmem Plasma unter Umgebungsdruck und gleichzeitig der Vermeidung von Rekombination und Überhitzung erfolgt. Auf diese Art und Weise ist es möglich, die genannten Limitierungen zu vermeiden, also ohne die Notwendigkeit der Verwendung eines Vakuums und ohne die Notwendigkeit der Verwendung von zusätzlichem oder externem Erwärmen. Weiterhin wird mit der hierin vorgestellten Verfahrensweise die Abnutzung der Materialien verringert, was mit den bisherigen Technologien nicht möglich ist. Zusätzlich sind neue Systeme gefunden worden, für die Herstellung von chemischen Energieträgern basierend auf dem Verfahren der vorliegenden Erfindung.

Die vorliegende Erfindung bietet eine alternative Lösung zu Elektrizitätserzeugung aus fossilen Brennstoffen und/oder aus Chemikalien auf fossiler Basis, indem im Rahmen der vorliegenden Erfindung intermittierend bereitstehende Energie aus erneuerbaren Quellen in chemische Energieträger umwandelt, welche dann gespeichert werden können und danach bei Bedarf zur Verfügung stehen.

Herkömmliche Technologien sind auf eine konstante Energieversorgung angewiesen, und erneuerbare Energien sind im Allgemeinen nicht gleichmäßig verfügbar, sondern liefern Energie, die nur intermittierend bzw. in schwankendem Umfang verfügbar ist, z. B. in Abhängigkeit von den Wetterbedingungen, so dass sie sich nicht für eine breite Palette von Anwendungen eignet.

Die vorliegende Erfindung erlaubt die effiziente Nutzung von fluktuierender, erneuerbarer Elektrizität für die schnelle Synthese von Treibstoffen und Chemikalien durch die gleichzeitige Aktivierung der chemischen Schleifenreaktionen (CL) oder Redoxreaktionen mit thermisch moduliertem Plasma (TMP),

Thermische Modulation des Plasmas bedeutet dabei, dass Strom an Gas bzw. Gasgemisch, welcher anschließend an die Plasmaerzeugung in dem Reaktionsraum auf den als Überträger entweder für Sauerstoff oder Stickstoff oder Wasserstoff oder Kohlenstoffdioxid fungierenden Feststoff bzw. Sauerstoffüberträger (Träger) trifft, in seiner Temperatur fluktuiert, also zu unterschiedlichen Zeiten mit unterschiedlichen Temperaturen auftrifft, insbesondere abwechselnd höhere Temperaturen und niedrigere Temperaturen aufweist. Zum Beispiel kann zunächst das Gas/Gasgemisch mit hoher Temperatur (zum Beispiel 50 ns mit 1500°C bis 2000°C) auf den Träger treffen und dann mit niedrigerer Temperatur (zum Beispiel 25 ns mit 350°C bis 650°C) und dann abwechselnd weiter.

Ein konkretes Beispiel für die thermische Modulation ist, wenn Mikrowellenenergie gepulst in die Plasmaerzeugungseinrichtung eingebracht wird und damit das Gas/Gasgemisch (Plasma) während der Mikrowelleneinwirkung auf zum Beispiel etwa 7000°K erhitzt wird und während der Nichtweinwirkung (also fehlendem Energieeintrag) abkühlt. Bei der Verwendung von Plasmalanzen, die an der Austrittsseite düsenartig ausgebildet sind, was erfindungsgemäß bevorzugt ist, tritt dann das Gas/Gasgemisch (Plasma) mit hoher Temperatur aus und in den Reaktionsraum ein, wo es expandiert und sich abkühlt, so dass beim Auftreffen auf den Träger dessen Temperatur nicht mehr (zum Beispiel) 7000K beträgt, sondern deutlich weniger, jedoch ausgehend von den durch die Mikrowellenpulse bedingten unterschiedlichen Ausgangstemperaturen im Gasfluss immer noch unterschiedlichen Temperaturen, zum Beispiel den eben genannten Temperaturbereichen. Die thermische Modulation ergibt sich also aus der Tatsache, dass der Gasfluss eine gerichtete (Zeit-)Komponente in Flussrichtung hat und bei intermittierendem Energieeintrag mithin an einem gegebenen Ort zu unterschiedlichen Zeitpunkten nicht immer den gleichen Energieinhalt transportiert (unterschiedliche Temperatur aufweist), sondern (gepulst) moduliert.

Die thermische Modulation eines Plasmas kann in manchen Varianten der vorliegenden Erfindung durch eine oder mehrere der folgenden Möglichkeiten erreicht werden:

1) Leistungsmodulation durch pulsierenden Energieeintrag in die Plasmaerzeugungseinrichtung, insbesondere von Mikrowellenplasma, was mit Pulsdauern von Femtosekunden, Nanosekunden, Mikrosekunden, Millisekunden oder Sekunden erfolgen kann;

2) die pulsierende Zuführung der Gase oder Reaktanten in die Plasmaerzeugungseinrichtung mit Pulsdauern im Bereich von Nanosekunden bis Sekunden, dann bevorzugt mit konstantem Energieeintrag, (zum Beispiel über geeignete Regelventile); oder die pulsierende Abfuhr, insbesondere pulsierende Absaugung, des Produktgasstroms;

3) die Pulsationen des Volumenstroms in der Plasmaerzeugungseinrichtung, im Reaktionsraum oder nach dem Träger mit Frequenzen, die die Gastemperatur dazu bringen mit einer Rate von höher als $10^3$ K/s zu fallen;

4) das Kühlen (>$10^3$ K/s) nach der Plasmaerzeugung mit Wärmetauschern oder Volumenstrommanagement;

5) die intermittierende Expansion der Reaktionsmischung von Drücken zum Beispiel >1 bar oder >5 bar;

6) die Trennung von wenigstens einem der Reaktanten, insbesondere Mittels Membran-unterstützter Selektion;

7) durch Wechselwirkung des Reaktionssystems mit anderen Materialien oder Verbindungen, insbesondere durch Einkoppeln von mindestens einer endothermen Reaktion kurz nach dem Austrittspunkt des Plasmas aus der Plasmaerzeugungsvorrichtung;

8) durch intermittierende Wechselwirkung des Gas-Stroms mit externer Energie, wobei die Energie elektromagnetische (z.B. Laserkühlung), elektrische (z.B. Peltier-Elemente), magnetische (z.B. magnetische Kühlung), thermische (Wärmetauscher) oder Schallenergie (Thermoakustische Kühlung) sein kann (aber nicht darauf limitiert ist).

In Varianten der vorliegenden Erfindung sind die Möglichkeiten 1) oder 2) jeweils für sich oder 1) und 2) in Kombination bevorzugt.

Als Plasmaerzeugungsvorrichtungen sind im Rahmen der vorliegenden Erfindung quasi beliebige übliche und erhältliche Vorrichtungen geeignet, die Plasma bilden können, bevorzugt Plasmalanzen. Beispiele für kommerzielle erhältliche Vorrichtungen sind zum Beispiel Plasmalanzen, Typ PS-CLE von Heuermann HF-Technik GmbH. Diese sind in der Lage im erfindungsgemäß bevorzugten Druckbereich zu arbeiten und Plasma zu bilden.

Als Mikrowellenerzeugungsvorrichtungen sind im Rahmen der vorliegenden Erfindung quasi beliebige übliche und erhältliche Vorrichtungen geeignet, bei denen Pulsdauer und Pulsfrequenz, insbesondere im Rahmen der erfindungsgemäß bevorzugten Pulsdauern und -frequenzen, einstellbar sind. Beispiele für kommerzielle erhältliche Vorrichtungen sind zum Beispiel Festkörpergeneratoren von HBH Microwaves GmbH. Beispielhaft, jedoch nicht für Reaktionen mit Feststoff-Überträgern für Sauerstoff oder Stickstoff oder Wasserstoff oder Kohlendioxid, wird eine Kombination von Plasmaerzeugungsvorrichtung und Mikrowellenerzeugungsvorrichtung in Soldatov, Sergey, et al. "Time-resolved optical emission spectroscopy reveals nonequilibrium conditions for CO2 splitting in atmospheric plasma sustained with ultrafast microwave pulsation." ACS Energy Letters 6.1 (2020): 124-130 beschrieben; zudem wird darin illustriert, dass Kühlungsraten gemäß obigem Punkt 3) von zum Beispiel $2*10^9$ K/s erreicht werden können.

Überträgermaterialien, bevorzugt zur Übertragung von Stickstoff, Wasserstoff, Kohlendioxid oder Sauerstoff, im Rahmen der vorliegenden Erfindung, in Varianten der vorliegenden Erfindung insbesondere Sauerstoffüberträgermaterialien, sind Materialien, die Ausgangsmaterialien oxidieren können und dann in einer separaten Reaktion selbst reoxidiert werden können (oder umgekehrt), in Varianten sind dies insbesondere Sauerstoffüberträgermaterialien. Diese Materialien können auch allgemein Trägermaterialien genannt werden.

Verschiedenste Überträgermaterialien, in Varianten insbesondere Sauerstoffüberträgermaterialien, können im Rahmen der vorliegenden Erfindung verwendet werden, abhängig von dem Atom, das während der Reaktion des CL-Prozesses ausgetauscht wird.

Die Materialien können in mindestens einer der folgenden Konfigurationen vorliegen: als Extrudate, als Pellets, als rotierendes Bett, als gepacktes-Bett-Reaktor, in Honigwabenform, als offenzelliger Schaum, als Fließbett, als Gitter, als Monolithen und dergleichen Ilmenit oder Hämatit, z.B. CeF-100 von Zircar Zirconia Inc.

Während der Reaktionen im Plasma können bei den Vorgehensweisen des Standes der Technik unerwünschte Rekombinationsreaktionen oder sekundäre Reaktionen auftreten, die in einem Verlust von Effizienz und Performance resultieren können und durch Verwendung von Vakuum zu verhindern versucht werden. Die vorliegende Erfindung hingegen beinhaltet wenigstens einen Strom mit thermisch-moduliertem Plasma (TMP). Dieser Wärme und aktive Spezies enthaltende Strom wird dann für die Erhitzung und gegebenenfalls simultane Aktivierung der Sauerstoffüberträgermaterialien (Träger) verwendet. Durch die Erwärmung und gegebenenfalls simultane Aktivierung der Sauerstoffüberträgermaterialien (Trägermaterialien) mit TMP ist es dann möglich, die Spezies und Energie, die durch das Plasma geliefert werden, effizient zu verwenden.

Zudem kann das Verfahren der vorliegenden Erfindung bei Umgebungsdruck (bevorzugt) oder höherem Drücken durchgeführt werden. Weiterhin ist es aufgrund der schnellen Dynamik (siehe Tabelle 1) des Verfahrens der vorliegenden Erfindung möglich, kurze Zeitfenster zu nutzen, in denen zum Beispiel der Preis der Elektrizität niedrig genug ist, das chemische Umwandlungen wirtschaftlich vorteilhaft sind.

Ein Gegenstand der vorliegenden Erfindung ist gerichtet auf Vorrichtungen und Verfahren für effiziente, schnelle und kompakte Produktion von Kohlenmonoxid, Wasserstoff oder Synthesegas aus Kohlendioxid, Wasser oder Kohlenwasserstoffen. Wie bereits vorher dargestellt, ist ein weit verbreitetes Problem in den Plasmatechnologien, dass Sauerstoff immer während der Aktivierung von stabilen Molekülen wie $CO_2$ oder Wasser zugegen ist, was die Entwicklung und Effizienz der Synthese der Energieträger hindert (Le Chatelier-Prinzip). Die simultane Plasmaerhitzung mittels gepulster Mikrowellenenergie gemäß der vorliegenden Erfindung ohne die Verwendung von Öfen und gegebenenfalls Aktivierung von Sauerstoffüberträgermaterialien erlaubt das schnelle Auffangen von Sauerstoff, wodurch Sicherheit, Effizienz und Ausbeuten erhöht werden.

Eine weitere Ausführungsform der Erfindung ist ein Verfahren zur schnellen Synthese von chemischen Energieträgern (siehe Tabelle 1). Die Erfindung nutzt thermischmoduliertes Plasma zur Erwärmung und gegebenenfalls Aktivierung von Sauerstoffüberträgermaterialien. Aufgrund der Fähigkeit von Plasma umgehend an- und ausgeschaltet zu werden, erlaubt diese Erfindung die Speicherung von intermittierender Energie entweder in den Sauerstoffüberträgermaterialien oder direkt in chemischen Verbindungen.

Eine weitere Ausführungsform der vorliegenden Erfindung ist eine Vorrichtung und Verfahren zur Herstellung von Ammoniak direkt aus Luft und Wasser. Bisher wurde dieses berichtet mit der Verwendung von lange dauernden Verfahren um hohe Temperaturen bereitzustellen, wie z. B. der Konzentration von Sonnenlicht. Im Rahmen der vorliegenden Erfindung ist durch direktes Plasmaerhitzen und Aktivieren von Redoxyklen von Sauerstoffüberträgermaterialien von Stickstoff und Wasser der Weg offen für neue kompakte und effiziente Technologien, die auf das elektrische Netz angepasst sind, um Ammoniak herzustellen.

Das Verfahren und die Vorrichtung dieser Ausführungsform umfassen zumindest einen der folgenden Schritte:

1. Erhalten eines stickstoffreichen Stromes von Luft in einem ersten CL-Schritt.
2. In einem anderen CL-Schritt kann ein Strom enthaltend Wasser und ein Strom enthaltend Stickstoff (z. B. aus Schritt 1) verwendet werden, um Ammoniak zu produzieren.

Ein weiterer Gegenstand der vorliegenden Erfindung sind ein Verfahren und eine Vorrichtung worin der Gittersauerstoff, der in einem oxidierten Sauerstoffüberträgermaterial vorhanden ist (z. B. stammend aus der Stickstoff-Trennung von Luft), für eine partielle Oxidation von Alkanen oder deren Umwandlung zu organischen Produkten und Olefinen verwendet wird.

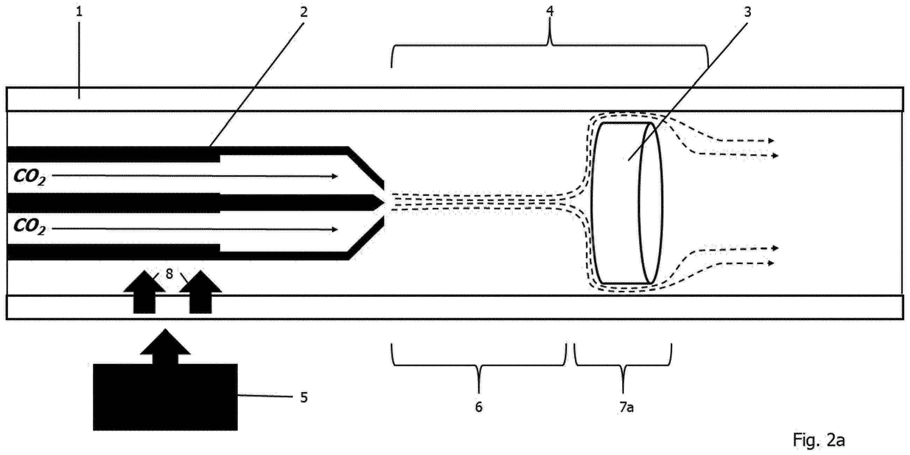

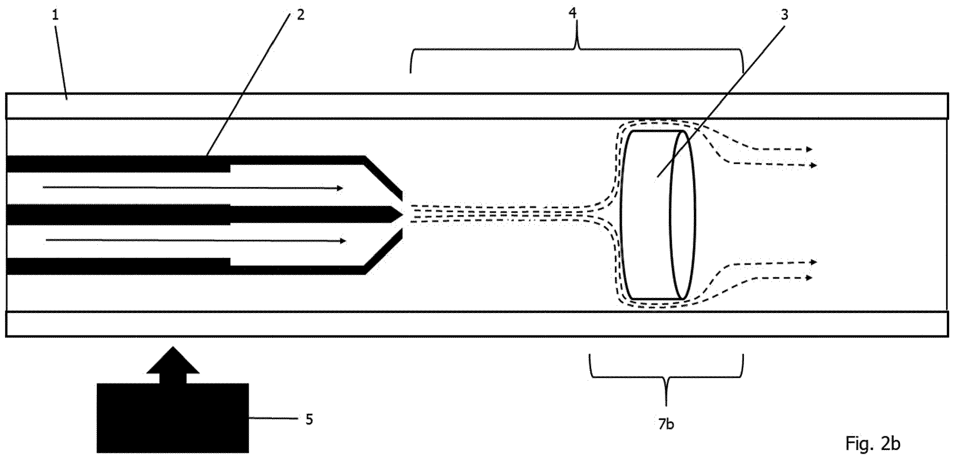

Die vorliegende Erfindung kann verwendet werden im Zusammenhang mit Gas-to-Liquid-Verfahren (z. B. Fischer-Tropsch oder Methanolsynthese) wobei deren Abgase verwendet werden können, um die Sauerstoffüberträgermaterialien zu reduzieren (wie in Figur 2 dargestellt).

Eine weitere Ausführungsform der vorliegenden Erfindung betrifft die Regeneration und Verwendung von relativ reichlich vorhandenen Sauerstoffüberträgermaterialien (Metall oder Keramik). Dazu werden Sauerstoffüberträgermaterialien und thermisch moduliertes Plasma in dem gleichen Reaktionsvolumen zusammengebracht, womit die Sauerstoffüberträgermaterialien erhitzt und gegebenenfalls gleichzeitig aktiviert werden.

Die vorliegende Erfindungsmeldung stellt unter anderem ein neues Verfahren zur effizienten Synthese von chemischen Energieträgern in Sekundenschnelle unter Verwendung von atmosphärisch warmem Plasma (d.h. bei Umgebungsdruck und in einem Temperaturbereich am Träger von zum Beispiel 400°C bis 1800°C) ohne Rekombination und Überhitzung vor. Dieses neue Verfahren vermeidet Rekombination und Überhitzung, die Notwendigkeit einer externen Heizung sowie Materialabrieb. Die Eigenschaft des Plasmas, sofort zu wirken, ermöglicht es, intermittierende Energie entweder im Trägermaterial (z.B. durch Aufnahme von Sauerstoff in dessen Matrix) oder direkt in chemischen Verbindungen zu speichern.

Beim Chemical Looping handelt es sich um einen Prozess, bei dem zwei oder mehr Redoxreaktionen eine Redoxschleife (oder einen Redoxyklus) bilden, zum Beispiel zur Gastrennung. Bei diesem Verfahren werden Sauerstoffüberträgermaterialien (chemische Zwischenprodukte) benötigt, um das Ausgangsmaterial zu oxidieren, die dann in einer separaten Reaktion reoxidiert werden können (bzw. zum Reduzieren und dann rereduziert werden).

Neu ist die Redox-Reaktionsschleife auf der Grundlage eines thermisch modulierten Plasmas (TMP) für die schnelle Synthese von Brennstoffen und Chemikalien durch die gleichzeitige Aktivierung der chemischen Schleifenreaktion (Redoxschleife/Redoxyklus).

Die thermische Modulation des Plasmas kann zum Beispiel wie oben dargestellt erfolgen, insbesondere durch gepulsten Eintrag von Mikrowellenenergie in eine Plasmaerzeugungsvorrichtung.

Bei der vorliegenden Erfindung wird mindestens ein Strom, der die umzusetzende Spezies (zum Beispiel COz) enthält, durch thermisch moduliertes Plasma erwärmt und aktiviert. Die Wärme des Stroms wird dann auch zur Erwärmung und Aktivierung der Sauerstoffüberträgermaterialien genutzt. Zu diesem Zeitpunkt findet die Redox-Reaktionsschleife zwischen Trägermaterial und aktiver Spezies statt.

Eine bevorzugte Ausführungsform der vorliegenden Erfindung betrifft eine Vorrichtung und ein Verfahren zur Herstellung von CO, Wasserstoff oder Synthesegas aus COz, Wasser oder Kohlenwasserstoffen. Im Falle von CO aus COz wird als das Sauerstoffüberträgermaterial bevorzugt Calciumoxid (CaO) oder Ceroxid ($Ce_2O_3$ oder CeOz, insbesondere CeOz), eingesetzt.

Die vorliegende Erfindung ist mithin insbesondere gerichtet auf die folgenden Gegenstände.

Ein weiterer, wichtiger Gegenstand der vorliegenden Erfindung ist eine Vorrichtung, bevorzugt zur Durchführung eines erfindungsgemäßen Verfahrens, insbesondere zur Durchführung von Chemical-Looping-Prozessen, umfassend oder bestehend aus

I) mindestens eine Zuleitungsvorrichtung für ein Gas oder Gasgemisch, konfiguriert das Gas oder Gasgemisch in eine Plasmaerzeugungsvorrichtung zu leiten,
II) eine Plasmaerzeugungsvorrichtung, konfiguriert, aus dem zugeführten Gas oder Gasgemisch, ein Plasma bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, zu erzeugen und in einen Reaktionsraum einzuleiten,
III) einem Reaktionsraum umfassend einen Feststoff, der als Überträger entweder für Sauerstoff oder Stickstoff oder Wasserstoff oder Kohlenstoffdioxid fungiert,
IV) Plasmamodulationseinrichtung, konfiguriert ein thermisch moduliertes Plasma gemäß einer der folgenden Varianten

1) Leistungsmodulation durch pulsierenden Energieeintrag in die Plasmaerzeugungseinrichtung;
2) pulsierende Zuführung der Gase oder Reaktanten in die Plasmaerzeugungseinrichtung mit Pulsdauern im Bereich von Nanosekunden bis Sekunden;
3) Pulsationen des Volumenstroms in der Plasmaerzeugungseinrichtung, im Reaktionsraum oder nach dem Träger mit Frequenzen, die die Gastemperatur dazu bringen mit einer Rate von höher als $10^3$ K/s zu fallen;
4) Kühlen nach der Plasmaerzeugung mit Wärmetauschern oder Volumenstrommanagement;
5) intermittierende Expansion der Reaktionsmischung auf Drücke von >1 bar;
6) Abtrennung von wenigstens einem der Reaktanten;
7) durch Wechselwirkung des Reaktionssystems mit anderen Materialien oder Verbindungen; oder
8) durch intermittierende Wechselwirkung des Gas-Stroms mit externer Energie,
zu erzeugen,

V) mindestens eine Ableitungsvorrichtung für Produktgas oder Produktgasgemisch, die stromabwärts des Reaktionsraumes angeordnet ist, wobei die Pulsdauer, Pulsfrequenz und die abgegebene Leistung von der Plasmamodulationseinrichtung zur Einstellung eines gewünschten Energieeintrages in Plasma und gegebenenfalls Feststoff-Überträger, voreinstellbar oder steuerbar ist. Eine bevorzugte Variante dieses Gegenstands ist dadurch gekennzeichnet, dass als Plasmamodulationseinrichtung
IV) eine Energieerzeugungsvorrichtung oder Mikrowellenerzeugungsvorrichtung, konfiguriert, die von ihr erzeugte Energie oder Mikrowellenenergie gepulst in das in die Plasmaerzeugungsvorrichtung eingeführte Gas oder Gasgemisch einzutragen und gegebenenfalls zusätzlich auf den als Überträger entweder für Sauerstoff oder Stickstoff oder Wasserstoff oder Kohlenstoffdioxid fungierenden Feststoff einwirken zu lassen, und bevorzugt konfiguriert, ein Plasma mit einem Energiegehalt von mindestens 1 eV zu erzeugen,

eingesetzt wird, wobei die Pulsdauer, Pulsfrequenz und die abgegebene Leistung der von der Mikrowellenerzeugungsvorrichtung erzeugten Mikrowellenenergie zur Einstellung eines gewünschten Energieeintrages in Plasma und gegebenenfalls Feststoff-Überträger, voreinstellbar oder steuerbar ist.

Ein weiterer, wichtiger Gegenstand der vorliegenden Erfindung ist mithin eine Vorrichtung, insbesondere zur Durchführung von Chemical-Looping-Prozessen, umfassend oder bestehend aus

I) mindestens eine Zuleitungsvorrichtung für ein Gas oder Gasgemisch, konfiguriert das Gas oder Gasgemisch in eine Plasmaerzeugungsvorrichtung zu leiten, wobei die Zuleitung und die Plasmaerzeugungsvorrichtung integriert ausgeführt sein können, oder verschiedene Bauteile, die miteinander in (Gasdichte) verbinden gebracht werden können,
II) eine Plasmaerzeugungsvorrichtung, konfiguriert, aus dem zugeführten Gas oder Gasgemisch, ein Plasma bei einem Druck von 5 bis 3000 $kPa_a$, bevorzugt 10 bis 100 kPa, besonders bevorzugt Umgebungsdruck plus/minus 10 kPa, insbesondere Umgebungsdruck plus/minus 1 kPa, zu erzeugen und in einen Reaktionsraum einzuleiten,

III) einem Reaktionsraum umfassend einen Feststoff, der als Überträger entweder für Sauerstoff, Stickstoff, Wasserstoff oder Kohlenstoffdioxid fungiert,

IV) eine Mikrowellenerzeugungsvorrichtung, konfiguriert, die von ihr erzeugte Mikrowellenenergie gepulst in das in die Plasmaerzeugungsvorrichtung eingeführte Gas oder Gasgemisch eintragen zu können und gegebenenfalls zusätzlich auf den als Überträger entweder für Sauerstoff, Stickstoff, Wasserstoff oder Kohlenstoffdioxid fungierenden Feststoff einwirken können zu lassen, und bevorzugt konfiguriert, ein Plasma mit einem Energiegehalt von mindestens 1 eV zu erzeugen, (1 eV = e * 1 V = 1,602176634 * $10^{-19}$ J)

V) mindestens eine Ableitungsvorrichtung für Produktgas oder Produktgasgemisch, die stromabwärts des Reaktionsraumes angeordnet ist,

wobei die Pulsdauer, Pulsfrequenz und die abgegebene Leistung der von der Mikrowellenerzeugungsvorrichtung erzeugten Mikrowellenenergie zur Einstellung eines gewünschten Energieeintrages in Plasma und Feststoff-Überträger, voreinstellbar oder steuerbar ist.

Es ist in Variationen der vorliegenden Erfindung möglich, eine Modulation des Plasmas, alternativ oder zusätzlich, insbesondere zusätzlich, zu der Einwirkung von Mikrowellenpulsen auf das Plasma, zum Beispiel gemäß einer der oben beschriebenen Möglichkeiten 2) bis 8) und 1) mit einer anderen Energie als Mikrowellenenergie, vorzunehmen.

Dies kann in Varianten durch pulsierte Einleitung des Gases oder Gasgemisches, oder zum Beispiel durch schnelle Gasabkühlung oder Gasexpansion. Durch die gepulste Zufuhr von Gasen, beispielsweise zur schnellen Abkühlung, sind im Rahmen der vorliegenden Erfindung weitere Möglichkeiten zur gezielten zeitabhängigen Modulation des Energiegehalts des Plasmas gegeben. Im Rahmen der vorliegenden Erfindung bieten die gepulste Zufuhr von Gasen oder die schnelle Abkühlung weitere Möglichkeiten zur gezielten zeitabhängigen Modulation des Energiegehalts des Plasmas, insbesondere zusätzlich zur Einwirkung von Mikrowellenpulsen.

Mikrowellenpulse sind im Rahmen der vorliegenden Erfindung zu verstehen als intermittierende Einwirkungen von Mikrowellenenergie durch ein oder Ausschalten der Mikrowellen oder durch intermittierende Änderung der eingestrahlten Mikrowellenleistung.

Das Plasma erwärmt dabei den Träger (Sauerstoffüberträger beziehungsweise Feststoff, der als Überträger entweder für Sauerstoff, Stickstoff, Wasserstoff oder Kohlenstoffdioxid fungiert). Dabei kann es den Träger gegebenenfalls gleichzeitig auch aktivieren. Aktivieren bedeutet dabei, dass der jeweilige Träger durch Aufnahme von Energie in einen Zustand versetzt wird, der die Übertragungsreaktion, insbesondere von Sauerstoff, Stickstoff, Wasserstoff oder Kohlendioxid, auf ihn oder in seine Struktur erleichtert oder erste möglich macht. Dabei ist der genaue Aktivierungsmechanismus abhängig vom jeweiligen Plasma und dem jeweiligen Trägermaterial und kann basieren auf thermischen Effekten, auf elektrischen Feldeffekten oder Strukturänderungen. Dies ist dem Fachmann im Prinzip bekannt, so dass er versteht, was gemeint ist, und braucht insofern nicht näher und insbesondere nicht im (molekularen) Detail beschrieben werden (wobei diese Details auch nicht in jedem Fall bekannt sind).

In Varianten der vorliegenden Erfindung hat das erzeugte Plasma einen Energiegehalt von mindestens 1 eV bis höchstens 10 eV.

Der in III) beschriebene Feststoff, der als Überträger entweder für Sauerstoff, Stickstoff, Wasserstoff oder Kohlenstoffdioxid fungiert, kann, in einigen Ausführungsformen, wie oben dargestellt ein Sauerstoffüberträger sein. In anderen Varianten der vorliegenden Erfindung kann er auch ein Stickstoffüberträger sein, zum Beispiel, wenn er eine Umsetzung eines Stickstoffplasmas oder eines Stickstoff enthaltenden Plasmas durchgeführt wird. In der Regel sind dafür die gleichen Materialien geeignet, insbesondere die im Folgenden beschriebenen Materialien.

Das Material für den Feststoff-Überträger für Sauerstoff, Stickstoff, Wasserstoff oder Kohlendioxid (Trägermaterial) wird in Abhängigkeit von der durchzuführenden Reaktion ausgewählt.

Bevorzugt wird das Material aus Metallen, Keramik, oder Metall-Keramik-Verbundwerkstoffen, bevorzugt auf Basis von Metallen, ausgewählt und weiter bevorzugt ausgewählt aus Metallen aus der Gruppe bestehend aus:

aus der II. Hauptgruppe des Periodensystems der Elemente insbesondere Ba, Ca, Mg, Sr,

aus der III. Hauptgruppe des Periodensystems der Elemente insbesondere Al, Ga,

aus der IV. Hauptgruppe des Periodensystems der Elemente insbesondere Sn,

aus der I. Nebengruppe des Periodensystems der Elemente insbesondere Cu,

aus der II. Nebengruppe des Periodensystems der Elemente insbesondere Zn,

aus der III. Nebengruppe des Periodensystems der Elemente insbesondere La,

aus der IV. Nebengruppe des Periodensystems der Elemente insbesondere Ti, Zr,

aus der V. Nebengruppe des Periodensystems der Elemente insbesondere V, Ce,

aus der VI. Nebengruppe des Periodensystems der Elemente insbesondere Cr, Mo, W,

aus der VII. Nebengruppe des Periodensystems der Elemente insbesondere Mn, U,

aus der VIII. Nebengruppe des Periodensystems der Elemente insbesondere Fe, Co, Ni,

und Kombinationen davon, besonders bevorzugt auf Basis von, insbesondere aus, Zirkoniumdioxid ($ZrO_2$), Ceroxid ($Ce_2O_3$ oder $CeO_2$, insbesondere Cerdioxid $CeO_2$), Calciumoxid (CaO), Aluminiumoxid ($Al_2O_3$), Magnesium-Aluminat ($MgAl_2O_4$) und Mischungen davon, insbesondere Cerdioxid oder Calciumoxid, oder von diesen Metallen und Keramiken abgeleiteten Metall-Keramik-Verbundwerkstoffen.

Die Materialien können in manchen Varianten als mikroporöse oder mesoporöse Teilchen vorliegen, wobei mikroporös bedeutet, dass mindesten 90% der Poren eine Porengröße kleiner als 2 nm aufweisen und mesoporös, dass mindesten 90% der Poren Porengrößen zwischen 2 nm und 5 nm aufweisen.

Der Feststoff-Überträger für Sauerstoff, Stickstoff, Wasserstoff oder Kohlendioxid (Träger) kann in verschiedenen Formen vorliegen, bevorzugt als Schüttung, Wanderbett oder Wirbelbett auf Basis von Partikeln oder Pellets, als strukturierte Packung, beispielsweise Extrudat, Schaum oder additiv gefertigte Struktur, oder als Beschichtung oder Mischungen davon, optional auf einem Träger oder zwischen Rückhaltevorrichtungen immobilisiert, bevorzugt als Wirbelbett oder additiv gefertigte Struktur, vorliegt.

In manchen Varianten der vorliegenden Erfindung werden die Partikel- oder Pelletgröße, Wanddicke strukturierter Packungen oder Schichtdicke sowie die Porengröße so gewählt, dass eine hohe äußere und innere Oberfläche für den Kontakt zwischen Feststoff und Gas resultiert.

Pellets werden dabei im üblichen Wortsinn als kleine Körper aus verdichtetem Material in Kugel- oder Zylinderform verstanden.

Die genaue Ausgestaltung der Anordnung des Feststoffs, der als Überträger entweder für Sauerstoff, Stickstoff, Wasserstoff oder Kohlenstoffdioxid fungiert, beziehungsweise Sauerstoffüberträgers (oder einfach Trägers) im Reaktionsraum kann durch den Fachmann anhand der Dimensionen des Reaktionsraums aufgrund seines allgemeinen Fachwissens ausgewählt werden und ist nicht besonders eingeschränkt. So ist dem Fachmann bekannt, dass Pellets zum Beispiel auf einem Sieb (oder in einem Sieb(-netz)) angeordnet werden können, Presslinge je nach Größe selbsttragend sein können und gegebenenfalls nur noch Auflagepunkte (Rastpunkte) an der Gefäßwand benötigen oder Gitterstrukturen mit dem Feststoff/Träger beschichtet werden können etc.

In bevorzugten Varianten der vorliegenden Erfindung wird die Mikrowellenenergie mit einem Pulsverhältnis eingeschaltet:ausgeschaltet von zwischen 1:1 und 3:1, bevorzugt 1,5:1 und 2,5:1, besonders bevorzugt bei 2:1, eingetragen.

In weiteren bevorzugten Varianten der vorliegenden Erfindung wird die Mikrowellenenergie mit einer eingeschalteten Dauer pro Puls von zwischen 20 ns und 100 ns, bevorzugt 30 ns bis 70 ns, besonders bevorzugt 50 ns, eingetragen.

In noch weiteren bevorzugten Varianten der vorliegenden Erfindung umfasst die Vorrichtung zusätzlich
VI) eine Vorrichtung zur Einleitung eines weiteren Gases oder Gasgemisches, insbesondere eines den Feststoff-Überträger für Sauerstoff, Stickstoff, Wasserstoff oder Kohlendioxid beziehungsweise Sauerstoffüberträger oxidierenden oder reduzierenden Gases oder Gasgemisches, in den Reaktionsraum. Durch die Einleitung dieses Gases oder Gasgemisches und Umsetzung am Feststoff-Überträger für Sauerstoff, Stickstoff, Wasserstoff oder Kohlendioxid beziehungsweise Sauerstoffüberträger wird dieser wieder in seinen Ausgangszustand, also bevor er an ihm das erste Gas oder Gasgemisch umgesetzt wurde, versetzt. Ob das Gas oder Gasgemisch dabei oxidierend oder reduzierend ist, hängt davon ab, ob das erste Gas oder Gasgemisch oxidierend oder reduzierend ist; dann weitere Gas erfüllt dann die komplementäre Bedingung, so dass beide Umsetzungen einen Redoxzyklus (beziehungsweise eine Redoxschleife) bilden. Im Rahmen der vorliegenden Erfindung wird meist von einem ersten, oxidierenden Gas oder Gasgemisch ausgegangen (das heißt es wird so beschrieben, so dass das weitere Gas oder Gasgemisch dann reduzierend ist, es ist aber auch umgekehrt möglich.

Dabei ist die Vorrichtung so konfiguriert, dass bei Einleitung dieses weiteren Gases oder Gasgemisches die Plasmaerzeugungsvorrichtung, und optional auch die Mikrowellenerzeugungsvorrichtung, aktiv oder inaktiv sein kann, bevorzugt inaktiv ist. In manchen Varianten ist diese Vorrichtung so konfiguriert, dass das Gas oder Gasgemisch aus der gleichen Düse austritt wie das aus der Plasmaerzeugungsvorrichtung kommende Plasma, insbesondere derart, dass die Zuleitung in und durch die Plasmaerzeugungsvorrichtung durch die gleiche Einlasseinrichtung erfolgt, wie das erste Gas oder Gasgemisch, und insbesondere durch ein Ventil zwischen erstem und weiterem Gas oder Gasgemisch umgestellt werden kann. Dadurch ist eine sehr kompakte Bauweise möglich.

Ein weiterer wichtiger Gegenstand der vorliegenden Erfindung ist ein Verfahren zur Umsetzung von Gasen oder Gasgemischen bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, umfassend die folgenden Schritte oder bestehend aus diesen:

A) Zuführen eines Gases oder Gasgemisches, insbesondere umfassend entweder Sauerstoff, Stickstoff oder Wasserstoff und/oder eine eines dieser Elemente enthaltende Verbindung, oder Kohlendioxid, mit einem Gehalt von mindestens 40 Vol.-%, bevorzugt mindestens 50 Vol.-%, besonders bevorzugt mindestens 75 Vol.-%, insbesondere mindestens 95 Vol.-%, des umzusetzenden Gases oder Gasgemisches, bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, in eine Plasmaerzeugungsvorrichtung;

B) Einleiten des so erzeugten Plasmas bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, in einen Reaktionsraum umfassend einen Feststoff-Überträger für Sauerstoff, Stickstoff, Wasserstoff oder Kohlendioxid;

C) Umsetzen des Plasmas am Feststoff-Überträger für Sauerstoff, Stickstoff, Wasserstoff oder Kohlendioxid, wobei das jeweilige Gas an den Feststoff-Überträger gebunden und dieser oxidiert, nitriert, hydriert oder karbonatisiert wird;

D) Ableiten des Produktgases bzw. Produktgasgemisches aus dem Reaktionsraum;

E) optional Regenerieren des Feststoff-Überträgers für Sauerstoff, Stickstoff, Wasserstoff oder Kohlendioxid durch Überleiten eines mit dem in C) erhaltenen Feststoff-Überträger in einem Plasma reagierenden, von dem in A) eingesetzten Gas oder Gasgemisch unterschiedlichen Gases oder Gasgemisches und Umsetzen dieses Gases oder Gasgemisches am Feststoff-Überträger, wodurch letzterer wieder in den Ausgangszustand versetzt wird und entweder gebundener Sauerstoff, Stickstoff, Wasserstoff oder gebundenes Kohlendioxid von dem Feststoff-Überträger freigesetzt wird und mit dem übergeleiteten Gas oder Gasgemisch reagiert;

wobei ein thermisch moduliertes Plasma gemäß einer der oben beschriebenen Varianten 1) bis 8) erzeugt wird, insbesondere das Plasma durch Pulse von Mikrowellenenergie gebildet und erwärmt wird, der Feststoff-Überträger für Sauerstoff, Stickstoff, Wasserstoff oder Kohlendioxid durch das gebildete Plasma erwärmt wird und optional zusätzlich durch Pulse von Mikrowellenenergie erwärmt wird, und wobei die Pulsdauer, Pulsfrequenz und die abgegebene Leistung der von der Mikrowellenerzeugungsvorrichtung erzeugten Mikrowellenenergie, zur Einstellung eines gewünschten Energieeintrages in Plasma und gegebenenfalls auf den Feststoff-Überträger für Sauerstoff, Stickstoff, Wasserstoff oder Kohlendioxid, voreingestellt und/oder gesteuert werden.

Die oben in Zusammenhang mit der erfindungsgemäßen Vorrichtung beschriebenen bevorzugten Ausgestaltungen und Varianten sind sinngemäß auch auf das Verfahren anzuwenden.

In Varianten der vorliegenden Erfindung werden beide Schritte C) und E) durchgeführt werden und bevorzugt dabei im Hinblick auf den Feststoff-Überträger für Sauerstoff, Stickstoff, Wasserstoff oder Kohlendioxid einen Reaktions-/Regenerationszyklus (Chemical Looping) darstellen.

In weiteren Varianten der vorliegenden Erfindung hat das erzeugte Plasma einen Energiegehalt von mindestens 1 eV bis höchstens 10 eV.

In weiteren Varianten der vorliegenden Erfindung

- umfasst das Gasgemisch in Schritt A) $CO_2$ und das Gasgemisch in Schritt E) Methan und Wasserstoff, oder
- als Gasgemisch in Schritt A) wird Luft oder stickstoffangereicherte Luft eingesetzt und in Schritt E) ein Gasgemisch umfassend Wasserdampf und gegebenenfalls Stickstoff; oder
- als Gasgemisch wird in Schritt A) Luft oder stickstoffangereicherte Luft eingesetzt und das Gasgemisch in Schritt E) umfasst Alkane, insbesondere C1 bis C4-n-Alkane.

In diesem Zusammenhang sei erwähnt, dass für die Reduzierung des Feststoff-Überträgers für Sauerstoff, Stickstoff, Wasserstoff oder Kohlendioxid bei der Ammoniak-Herstellung (zweiter Spiegelstrich) bevorzugt ein Wasser: Stickstoff-Verhältnis im Feedgas von 0,5:1 bis 1:10 eingestellt wird, bevorzugt 0,8:1 bis 1,8:1, besonders bevorzugt 1,0;1 bis 1,6:1, insbesondere 1:1,3.

Ferner sind wichtige Gegenstände der vorliegenden Erfindung die nachfolgend genannten Verwendungen:

Verwendung der erfindungsgemäßen Vorrichtung oder des erfindungsgemäßen Verfahrens zur Herstellung

- von Olefinen mittels partieller Oxidation von Alkanen, wobei zunächst im ersten Schritt des Redoxzyklus Sauerstoff in dem Feststoff-Überträger für Sauerstoff, Stickstoff, Wasserstoff oder Kohlendioxid beziehungsweise Sauerstoffüberträger gespeichert wird (unter vorheriger Spaltung von zum Beispiel $CO_2$) und dann im zweiten Schritt des Redoxzyklus ein Alkan (zum Beispiel Methan) in einem Regenerationsschritt an dem Feststoff-Überträger für Sauerstoff, Stickstoff, Wasserstoff oder Kohlendioxid beziehungsweise Sauerstoffüberträger umgesetzt wird,
- von Ammoniak aus Luft und Wasser, oder
- von Kohlenmonoxid aus Kohlendioxid,

bevorzugt von Ammoniak aus Luft und Wasser, oder von Kohlenmonoxid aus Kohlendioxid, insbesondere von Kohlenmonoxid aus Kohlendioxid,
oder

- zur Herstellung chemischer Energieträger ausgehend von mittels erneuerbarer Energien zur Verfügung gestelltem Strom, insbesondere CO, $H_2$, Ammoniak, Olefine oder den oxidierten, nitrierten, hydrierten oder karbonatisierten Feststoff-Überträger für Sauerstoff, Stickstoff, Wasserstoff oder Kohlendioxid, beziehungsweise Sauerstoffüberträger,

- in oder gekoppelt mit Fischer-Tropsch-Anlagen, bevorzugt zur Herstellung von CO, $H_2$ oder Synthesegas, insbesondere gekoppelt mit Anlagen zur Fischer-Tropsch-Synthese oder Methanolsynthese,

oder

- zur Umsetzung von Strom, bevorzugt Stromspitzen, besonders bevorzugt überschüssigem Strom, insbesondere durch erneuerbare Energietechnik erzeugten überschüssigem Strom, in speicherbare Energie in Form chemischer Verbindungen.

Aufgrund des Umstandes, dass bei der erfindungsgemäßen Vorgehensweise ein Eduktgas zugeführt und ein Produktgas abgeführt wird, ergibt sich ein gerichteter Strom, womit auch das aus dem Eduktgas erzeugte Plasma ein gerichteter Plasmastrom ist, der im Reaktionsraum in Richtung des Feststoff-Überträgers für Sauerstoff, Stickstoff, Wasserstoff oder Kohlendioxid beziehungsweise Sauerstoffüberträgers strömt.

Eine spezielle Variante der vorliegenden Erfindung ist eine Vorrichtung, insbesondere zur Durchführung von Chemical-Looping-Prozessen, umfassend

I) mindestens eine Zuleitungsvorrichtung für ein Gas oder Gasgemisch, konfiguriert das Gas oder Gasgenmisch in eine Plasmaerzeugungsvorrichtung zu leiten,

II) eine Plasmaerzeugungsvorrichtung, konfiguriert, aus dem zugeführten Gas oder Gasgemisch, ein Plasma bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, zu erzeugen und in einen Reaktionsraum einzuleiten,

III) einem Reaktionsraum umfassend einen Feststoff-Sauerstoffüberträger,

IV) eine Mikrowellenerzeugungsvorrichtung, konfiguriert, die von ihr erzeugte Mikrowellenenergie gepulst in das in die Plasmaerzeugungsvorrichtung eingeführte Gas oder Gasgemisch einzutragen und gegebenenfalls zusätzlich auf den Feststoff-Sauerstoffüberträger einwirken zu lassen, und bevorzugt konfiguriert, ein Plasma mit einem Energiegehalt von mindestens 1 eV zu erzeugen,

V) mindestens eine Ableitungsvorrichtung für Produktgas oder Produktgasgemisch, die stromabwärts des Reaktionsraumes angeordnet ist, wobei die Pulsdauer, der von der Mikrowellenerzeugungsvorrichtung erzeugten Mikrowellenenergie, zur Einstellung eines gewünschten Energieeintrages in Plasma und Feststoff- Sauerstoffüberträger, voreinstellbar oder steuerbar ist.

Eine weitere spezielle Variante der vorliegenden Erfindung ist ein Verfahren zur Umsetzung von Gasen oder Gasgemischen bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, umfassend die folgenden Schritte oder bestehend aus diesen:

A) Zuführen eines Gases oder Gasgemisches, bevorzugt umfassend Sauerstoff und/oder Sauerstoff enthaltende Moleküle, mit einem Gehalt von mindestens 40 Vol.-%, bevorzugt mindestens 50 Vol.-%, besonders bevorzugt mindestens 75 Vol.-%, insbesondere mindestens 95 Vol.-%, Sauerstoff und/oder Sauerstoff enthaltende Moleküle, höchst bevorzugt ein Gasgemisch enthaltend mindestens 50 Vol.-% oder mindestens 75 Vol.-% oder mindestens 95 Vol.-% oder mindestens 99 Vol.-% COz, in eine Plasmaerzeugungsvorrichtung;

B) Einleiten des so erzeugten Plasmas in einen Reaktionsraum umfassend einen Feststoff-Sauerstoffüberträger;

C) Umsetzen des Plasmas am Feststoff-Sauerstoffüberträger, wobei Sauerstoff an den Feststoff-Sauerstoffüberträger gebunden und dieser oxidiert wird;

D) Ableiten des Produktgases bzw. Produktgasgemisches aus dem Reaktionsraum;

E) optional Regenerieren des Feststoff-Sauerstoffüberträgers durch Überleiten eines bevorzugt reduzierend auf den in C) erhaltenen Feststoff-Sauerstoffüberträger wirkenden, von dem in A) eingesetzten Gas oder Gasgemisch unterschiedlichen Gases oder Gasgemisches, bevorzugt umfassend hauptsächlich Wasser und/oder keine Sauerstoff enthaltenden Moleküle, besonders bevorzugt Alkane, insbesondere Methan und Wasserstoff, und Umsetzen des Gases am Feststoff-Sauerstoffüberträger, wodurch letzterer reduziert wird und gebundener Sauerstoff von dem Feststoff-Sauerstoffüberträger freigesetzt wird und mit dem übergeleiteten Gas oder Gasgemisch reagiert;

wobei das Plasma durch Pulse von Mikrowellenenergie gebildet und erwärmt wird, der Feststoff-Sauerstoffüberträger durch das gebildete Plasma erwärmt wird und optional zusätzlich durch Pulse von Mikrowellenenergie erwärmt wird

und wobei die Pulsdauer, der von der Mikrowellenerzeugungsvorrichtung erzeugten Mikrowellenenergie, zur Einstellung eines gewünschten Energieeintrages in Plasma und Feststoff- Sauerstoffüberträger, voreingestellt und/oder gesteuert werden.

Bei diesen speziellen Varianten der vorliegenden Erfindung wird der Feststoff-Sauerstoffüberträger bevorzugt ausgewählt aus Metall, Keramik, oder Metall-Keramik-Verbundwerkstoffen, bevorzugt aus der Gruppe bestehend aus Cerdioxid, Calciumoxid und Mischungen davon, insbesondere Cerdioxid, wobei der Feststoff-Sauerstoffüberträger weiterhin als Extrudat, Pellet, Schaum, Beschichtung, Schüttung oder Mischungen davon, optional auf einem Träger oder zwischen Rückhaltevorrichtungen immobilisiert, besonders bevorzugt als Pellet, vorliegt.

Bei diesen speziellen Varianten der vorliegenden Erfindung ist es zudem manchmal bevorzugt, zusätzlich zu der thermischen Modulation über Mikrowellenpulse, die Eduktgaszufuhr und/oder die Produktgasabfuhr gepulst zu gestalten, zum Beispiel durch kurze Druckstöße bei der Eduktgaszufuhr und/oder kurze Saugimpulse bei der Produktgasabfuhr, dies kann insbesondere auch auf die Pulsmodulation der Mikrowellen abgestimmt sein.

Im Übrigen sind auch bei diesen speziellen Varianten die weiter oben oder unten ausgeführten speziellen Ausgestaltungen, Varianten und Gegenstände sinngemäß anwendbar.

Die erfindungsgemäße Vorrichtung ist für sich allein einsetzbar und nicht an den Einsatz im oder für ein Chemical Looping gebunden. Wie oben beschrieben, kann die erfindungsgemäße Vorrichtung für einzelne oder beide Schritte eines Redoxzyklus verwendet werden (wobei gegebenenfalls in einem Schritt die Mikrowellenerzeugungsvorrichtung nicht oder nicht mit der gleichen Leistung betrieben wird), wobei aber zu berücksichtigen ist, dass eine erfindungsgemäße Vorrichtung zu einem gegebenen Zeitpunkt nur einen Schritt eines Redoxzyklus ausführen kann. Für eine kontinuierliche Fahrweise eines Redoxzyklus sind also der alternierende Betrieb einer erfindungsgemäß Vorrichtung oder der simultane Betrieb zweier erfindungsgemäßer Vorrichtungen denkbar. Es ist außerdem denkbar, dass der zweite Schritt mittels einer anderen Vorrichtung durchgeführt wird. Eine weiter Variante der vorliegenden Erfindung ist, eine erfindungsgemäße Vorrichtung, bei der mehrere Exemplare des Feststoffs, der als Überträger entweder für Sauerstoff, Stickstoff, Wasserstoff oder Kohlenstoffdioxid fungiert, beziehungsweise des Sauerstoffüberträgers in einer Art Revolvermagazin gelagert sind, die dann je nach Bedarf in den Reaktionsraum einrotiert werden können. Selbstverständlich ist es auch möglich, die Redoxschleifen auf mehr als zwei Schritte auszudehnen, um die Energiestufen, die für einzelne Schritte notwendig sind besser anpassen zu können, oder um gezielt mehrere Zwischenprodukte zu erhalten, dann können auch mehr als zwei erfindungsgemäße Vorrichtungen (nacheinander) eingesetzt werden, zum Beispiel drei oder vier oder fünf oder noch mehr erfindungsgemäße Vorrichtungen. Alle diese Ausgestaltungen sind von der vorliegenden Erfindung umfasst.

Mit der vorliegenden Erfindung lassen sich so gute Ergebnisse und Effekte erzielen, weil die im Plasma erzeugten beziehungsweise vorhandenen reaktiven Spezies in einem Reaktionsraum mit dem Feststoff, der als Überträger für Sauerstoff oder Stickstoff oder Wasserstoff oder Kohlenstoffdioxid fungiert, beziehungsweise Sauerstoffüberträger, vorliegen, direkt genutzt werden.

Es ist im Rahmen der vorliegenden Erfindung in speziellen Varianten auch möglich Gasgemische umsetzen, die verschiedene Spezies aufweisen, so dass der Träger dann als Überträger für gleichzeitig Sauerstoff, Stickstoff, Wasserstoff und/oder Kohlenstoffdioxid fungiert.

Als Vorteile der vorliegenden Erfindung können zum Beispiel folgende genannt werden:

- Durch das unmittelbare ansprechen des erfindungsgemäßen Verfahrens ist es möglich im Stromnetz anfallende Stromspitzen zu nutzen, um die Energie in umgewandelter Form dann in chemischer Energie zu speichern. Abgesehen von den Vorteilen gespeicherter Energie an sich ist es ein nicht zu unterschätzender Vorteil der vorliegenden Erfindung, dass diese Stromspitzen abgefangen werden und damit das Stromnetz stabilisiert werden kann.
- Die Trägermaterialien (zum Beispiel Sauerstoffüberträgermaterialien) werden schnell aktiviert.
- Eine unverzügliche An- und Ausschaltung ist möglich.
- Die Verfahren der vorliegenden Erfindung verhindern die Rekombination von chemischen Verbindungen, die in Plasmas erhalten werden, was die Ausbeute und Effizienz erhöht.
- Die hohe Elektronenenergie von TMP (>1 eV) erlaubt es, stabile Bindungen wie solche von $CO_2$, Wasser oder Stickstoff zu brechen.
- Das Ausmaß der Reaktionen kann genau gesteuert werden, indem die Pulse, insbesondere der Mikrowellenerzeugungsvorrichtung, gesteuert werde (in Dauer und/oder Stärke).
- Ein Vorteil der vorliegenden Erfindung ist, dass keine Elektroden basierend auf seltenen bzw. teuren Elementen nötig sind/verwendet werden müssen.

Mit der vorliegenden Erfindung sind Mikrowellenergie-zu-Brennstoff-Effizienzen von größer als 40%-60% bei atmosphärischem Druck erreichbar (siehe Tabelle 1). Dies liegt jenseits dessen, was bisher in Plasma-$CO_2$-Spaltung bei atmosphärischem Druck offenbart wurde und eröffnet mithin die Möglichkeit von effizienter Verwendung von fluktuierender, erneuerbarer Elektrizität für die schnelle Synthese von Brennstoffen und Chemikalien

Aufgrund der Eigenschaft von Plasma umgehend oder unverzüglich an- und ausgeschaltet werden zu können, erlaubt die vorliegende Erfindung die Speicherung von intermittierender Energie entweder in den Sauerstoffüberträgermaterialien oder direkt in chemischen Verbindungen.

Im Falle von Prozessen wie Kohlendioxidspaltung, COz und Wasserreduktion oder Trockenreformierung extrahiert das Verfahren gemäß vorliegende Erfindung Sauerstoff aus dem Produkt, wodurch die Reaktion weiter angetrieben wird.

Die Ammoniak-Synthese kann in kompakten Systemen basierend nur auf Wasser und Luft ausgeführt werden, unter Verwendung von Elektrizität aus intermittierenden erneuerbaren Energiequellen.

Die Umsetzung von Alkanen und andere Kohlenwasserstoffe in nützliche Ausgangsstoffe wie zum Beispiel Synthesegas ist ebenfalls mit der vorliegenden Erfindung möglich (zum Beispiel mittels partieller Oxidation). Dies erlaubt die Integration der erfindungsgemäß Verfahren in andere Verfahren in einem Power-to-X Kette wie z.B. Fischer-Tropsch.

Die vorliegende Erfindung ist besonders gut geeignet intermittierende Energieversorgung auszunutzen. Die vorliegende Erfindung basiert auf einem unmittelbaren Starten und Ausschalten von TMP, womit gleichzeitig Sauerstoffüberträgermaterialien erhitzt und aktiviert werden (können).

Das Trägermaterial (zum Beispiel Sauerstoffüberträgermaterial) kann im Rahmen der vorliegenden Erfindung regeneriert werden und (auch) alternativ verwendet werden. Im Rahmen der vorliegenden Erfindung ist der Betrieb bei atmosphärischem Druck oder höher möglich. Im Rahmen der vorliegenden Erfindung können Trägermaterialien (zum Beispiel Sauerstoffüberträgermaterialien) verwendet werden, die auf Keramik, Metall oder Salzen basieren.

Auftretende Probleme wie die der Abbau von Trägermaterial (zum Beispiel Sauerstoffüberträgermaterial) abhängig von dem Ort und den Operationsbedingungen bzw. der Abbau von Produkten, falls kein angemessenes Reaktordesign verwendet wird, können durch thermische Modulation des Plasmas gelöst werden, wie es oben beschrieben ist (einschließlich zum Beispiel Gaskühlung, Flussmanagement, Zyklusoptimierung, Anpassung des Plasmas und Materialentwicklung).

Die vorliegende Erfindung kann auf dem Gebiet der Treibstoffe und Chemikalien, der Energiespeicherung, der verteilten Energiesysteme, der Gassäuberung sowie Power-to-X verwendet werden.

Die vorliegende Erfindung kann für die Herstellung von chemischen Energieträgern wie z. B. Kohlenmonoxid, Wasserstoff, C2-Produkten, Olefinen, Synthesegas oder Ammoniak verwendet werden, die dann noch weiter umgesetzt oder gespeichert werden können. Zusätzlich kann die vorliegende Erfindung verwendet werden im Zusammenhang mit anderen Treibstoffherstellungsverfahren, die reduzierende Gase bereitstellen (zum Beispiel Wasserstoff oder Methan aus Fischer-Tropsch), um die Trägermaterialien zu reduzieren oder die Herstellung von Energieträgern zu erhöhen.

Im Rahmen der vorliegenden Erfindung wird es durch den direkten Kontakt von thermisch moduliertem Plasma mit Feststoff-Überträgern möglich, Chemical-Looping-Prozesse durchzuführen, insbesondere auch zur Herstellung

- von Olefinen mittels partieller Oxidation von Alkanen,
- von Ammoniak aus Luft und Wasser, oder
- von Kohlenmonoxid aus Kohlendioxid, bevorzugt von Ammoniak aus Luft und Wasser, oder von Kohlenmonoxid aus Kohlendioxid, insbesondere von Kohlenmonoxid aus Kohlendioxid, und/oder
- zur Herstellung chemischer Energieträger ausgehend von mittels erneuerbarer Energien zur Verfügung gestelltem Strom, insbesondere CO, H2, Ammoniak, Olefine oder den oxidierten, nitrierten, hydrierten oder karbonatisierten Feststoff-Überträger für Sauerstoff, Stickstoff, Wasserstoff oder Kohlendioxid
- in oder gekoppelt mit Fischer-Tropsch-Anlagen, bevorzugt zur Herstellung von CO, H2 oder Synthesegas, insbesondere gekoppelt mit Anlagen zur Fischer-Tropsch-Synthese oder Methanolsynthese.

Die einzelnen Teile der erfindungsgemäßen Vorrichtungen stehen in fachüblicher und bekannter Art und Weise miteinander in Wirkverbindung.

Die verschiedenen Ausgestaltungen der vorliegenden Erfindung, z.B. - aber nicht ausschließlich - diejenigen der verschiedenen abhängigen Ansprüche oder einzelner in den Figuren beschriebenen Ausgestaltungen, können dabei in beliebiger Art und Weise miteinander kombiniert werden, sofern solche Kombinationen sich nicht widersprechen.

Die im Folgenden mit Bezugnahme auf die Figuren näher erläuterten Ausführungsformen der vorliegenden Erfindung stellen verschiedene bevorzugte Ausführungsformen dar, viele der im Folgenden in einzelnen Figuren dargestellten Merkmale bzw. Ausführungsformen sind mit in anderen Figuren oder der übrigen Beschreibung dargestellten Merkmalen und Ausführungsformen kombinierbar, insbesondere wo die Merkmale entsprechend beschrieben sind. So können zum Beispiel verschiedene in den Figuren dargestellte Ausgestaltungen in einer erfindungsgemäßen Vorrichtung kombiniert werden. Die Figuren sind überdies nicht limitierend auszulegen und nicht maßstabsgetreu. Weiterhin enthalten die Figuren nicht alle Merkmale, die übliche Vorrichtungen/Anlagen aufweisen, sondern sind auf die für die vorliegende Erfindung und ihr Verständnis wesentlichen Merkmale reduziert, beispielsweise sind Schrauben, Halterungen etc. nicht oder nicht im Detail dargestellt.

Gleiche Bezugszeichen/-ziffern bedeuten dabei gleiche oder gleichwirkende Vorrichtungsteile.

Nachfolgend wird kurz erläutert, wie eine Schleifenreaktion (chemical looping) in manchem Varianten der vorliegenden Erfindung ablaufen kann. Zentraler Punkt ist dabei das thermisch modulierte Plasma, das zudem im gleichen Reaktionsraum vorliegt, wie der Sauerstoffüberträger. Denn dadurch wird es möglich, durch gezielten Eintrag von Energie, bevorzugt Mikrowellenenergie in frisch erzeugtes Plasma dieses bei Umgebungsdruck ausreichend zu erwärmen, so dass dadurch auch eine Erwärmung und Aktivierung des Sauerstoffüberträgers erfolgen kann. Bei dem einen Schritt der Schleife wird der Sauerstoffüberträger oxidiert, wodurch gleichzeitig reduzierte Produkte entstehen, die dann entweder schon das gewünschte Produkt darstellen, oder Intermediate beziehungsweise Zwischenprodukte sein können. Der so oxidierte Sauerstoffüberträger kann in den zweiten Schritt der Schleife wieder reduziert werden, indem er mit einem energetischen Reaktanten kontaktiert wird. Zusätzlich kann optional auch bei diesem Schleifenschritt thermisch moduliertes Plasma mitverwendet werden. Die beiden Schleifenschritte können alternierend beliebig oft (theoretisch, praktisch ermüdet jedes Material irgendwann) durchgeführt werden, da der Sauerstoffüberträger quasi jederzeit wieder regeneriert wird.

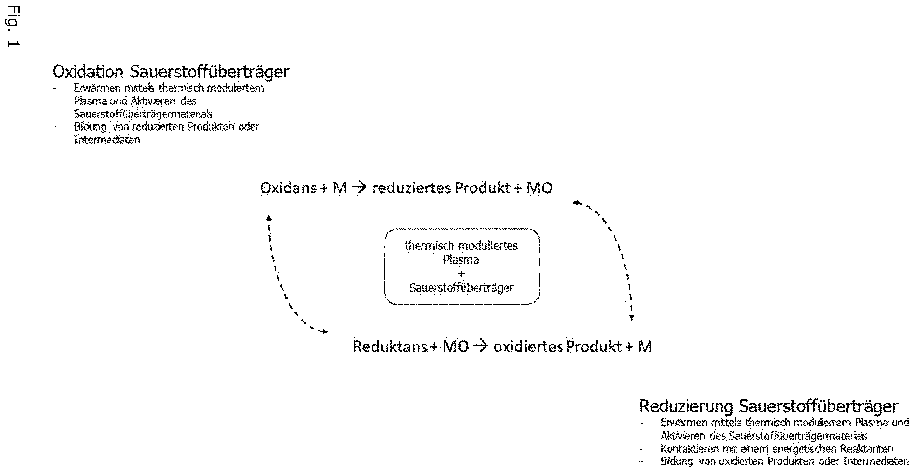

Figur 1 zeigt schematisch einen solchen Ablauf.

Figur 2 zeigt eine erfindungsgemäße Vorrichtung, wobei in Figur 2a ein Oxidationsschritt einer Redoxschleife (oder auch Redoxzyklus) dargestellt ist und in Figur 2b der zugehörige Reduktionsschritt. Dargestellt ist eine Vorrichtung umfassend eine Plasmaerzeugungsvorrichtung 2, eine Mikrowellenerzeugungsvorrichtung 5, einen Sauerstoffüberträger 3. In dem gezeigten Fall befinden sich die Plasmaerzeugungsvorrichtung und der Sauerstoffüberträger in einer diese beiden umhüllenden Glasröhre 1 (ähnlich wie dies bei den erfindungsgemäßen Beispielen der Fall war). Es ist aber genausogut möglich, dass zum Beispiel von der Plasmaerzeugungsvorrichtung lediglich die Austrittsöffnung in einer äußeren Umhüllung ist. Wesentlich ist nur, dass das austretende Plasma und der Sauerstoffüberträger 3 in einem Reaktionsraum 4 vorliegen. In der Figur 2a wird von links Eduktgas in die Plasmaerzeugungsvorrichtung 2 eingedüst, zum Beispiel $CO_2$ bei Umgebungsdruck und etwa 300K. In der Plasmaerzeugungsvorrichtung 2 wird aus dem Eduktgas ein Plasma erzeugt, dass an der rechten Seite der Vorrichtung in den Reaktionsraum 4 austritt. Das Plasma kann dabei durch die Mikrowellenerzeugungsvorrichtung 5 thermisch moduliert werden, indem Mikrowellenpulse 8 auf das Plasma einwirken. Es sei darauf hingewiesen, dass der Übersichtlichkeit halber in dieser Figur die Mikrowellenerzeugungsvorrichtung 5 so dargestellt ist, dass sie das Plasma mit Mikrowellenpulsen beaufschlagen kann. Es ist aber auch möglich, dass die Mikrowellenerzeugungsvorrichtung 5 so groß ausgestaltet ist, dass auch der Reaktionsraum 4 und der Sauerstoffüberträger 3 mit Mikrowellen beaufschlagt werden können. Das im Unterabschnitt 6 befindliche Plasma weist für den Fall der $CO_2$-Zuführung unter anderem CO und O sowie gegebenenfalls $O_2$ auf. Am Sauerstoffüberträger 3, dem Unterabschnitt 7a, findet dann sozusagen eine Sauerstoffspeicherung statt. Im Falle von $CO_2$ als Ausgangsstoff zum Beispiel gemäß $CO_2 + M \rightarrow CO + MO$ (M= Metall des Sauerstoffüberträgers, insbesondere $CeO_2$ falls $CO_2$ umgesetzt werden soll) oder im Plasma gebildetes $O_2 + CO + M \rightarrow CO + MO$. Es wird also in diesem Falle CO als Produkt (oder Zwischenprodukt/Intermediat) freigesetzt und oxidierter Sauerstoffüberträger 3 (MO) erhalten. Das Produktgas tritt rechts aus der Vorrichtung aus und kann dann entweder gespeichert oder direkt weiterverwendet werden. CO kann beispielsweise einer Fischer-Tropsch-Anlage zugeführt werden.

Figur 2b zeigt die gleiche Vorrichtung, wobei der zur Redoxschleife gehörige Reduktionsschritt illustriert ist. Das Eduktgas für diesen Schritt wird wieder von links zugeführt und kann in diesem Beispiel das Abgas aus einer Fischer-Tropsch-Anlage sein. In diesem Falle ist es nicht notwendig, ein Plasma zu erzeugen und Mikrowellenpulse zu beaufschlagen, deshalb sind hier in Figur 2b keine Mikrowellenpulse 8 gezeigt. Am Sauerstoffüberträger 3, dem Unterabschnitt 7b, findet dann der zu Figur 2a inverse Prozess statt, das heißt der Sauerstoffüberträger 3 wird nun reduziert, wobei dies im gewählten Beispiel unter anderem gemäß $CH_4 + H_2 MO \rightarrow CO + M + H_2O$ abläuft (Methan und Wasserstoff stammen aus dem Eduktgas). Es werden also in diesem Falle CO und Wasser als Produkt (oder Zwischenprodukt/Intermediat) freigesetzt und reduzierter Sauerstoffüberträger 3 (M) erhalten. Das Produktgas tritt rechts aus der Vorrichtung aus und kann dann entweder gespeichert oder direkt weiterverwendet werden. Das hier beispielhaft gezeigt Gas enthaltend CO und $H_2O$ kann beispielsweise einer Wassergasshift-Anlage zugeführt werden.

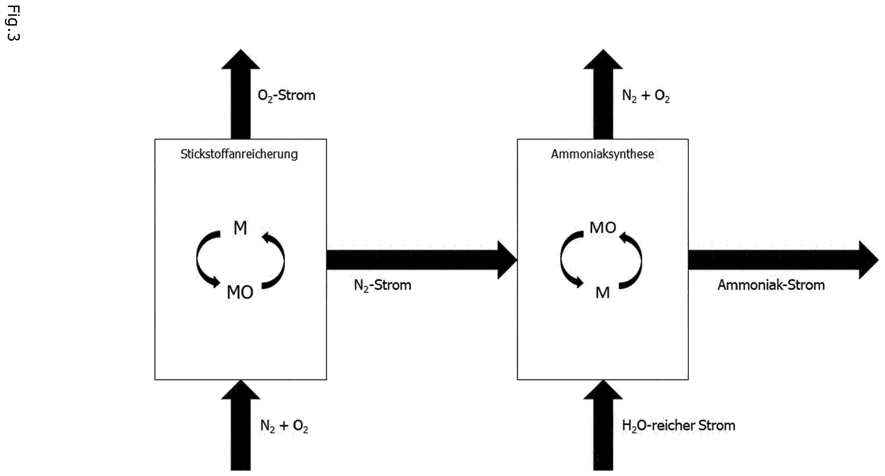

Figur 3 zeigt eine erfindungsgemäße Anwendung der erfindungsgemäßen Vorrichtungen bzw. Verfahren unter Verwendung von thermisch moduliertem Plasma und Sauerstoffüberträgern zur Herstellung von Ammoniak, der zum Beispiel als Energiespeicherstoff dienen kann. In linken Teil ist dargestellt, dass als Eduktgas Stickstoff und Sauerstoff zugeführt werden können, zum Beispiel (bevorzugt) Luft. Am Sauerstoffüberträger wird dann das thermisch modulierte Plasma umgesetzt und Sauerstoff gebunden und Stickstoff-angereichertes (beziehungsweise Sauerstoffabgereichertes) Gas oder reiner Stickstoff können abgeleitet werden. Die Regenration des Sauerstoffüberträgers kann dann einen sauerstofffreien Strom ergeben, der als weiteres Produkt verwendbar ist. Der Stickstoffstrom kann dann in einem weiteren Schritt unter Verwendung einer erfindungsgemäßen Vorrichtung beziehungsweise des erfindungsgemäßen Verfahrens und mit Zudosierung eines Wasser-reichen Stroms zu Ammoniak umgesetzt werden. Dies illustriert eindrücklich die Stärken der vorliegenden Erfindung, denn es ist möglich bei Umgebungsdruck die recht starke N2-Bindung zu brechen und eine Umsetzung damit wirtschaftlich lohnenswert zu machen.

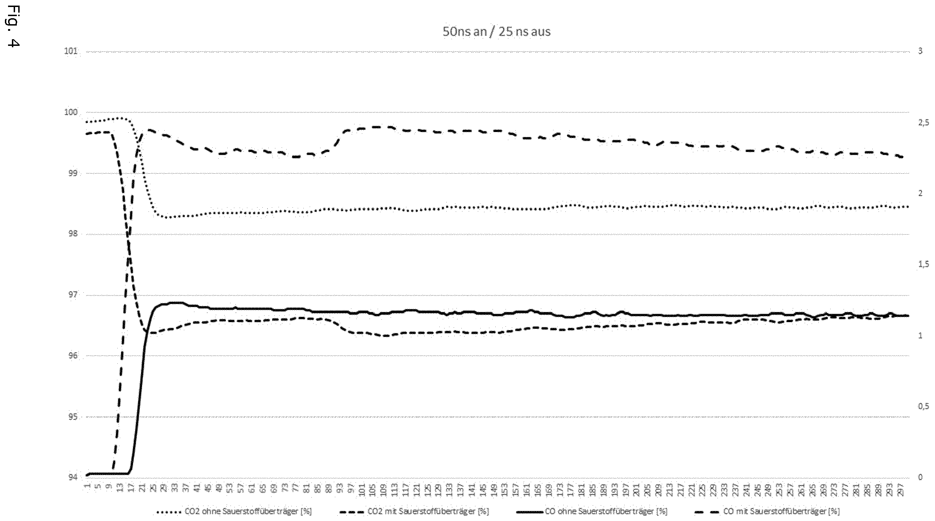

Figur 4 zeigt grafisch aufgetragen die Ergebnisse für 300 sekündliche Messungen für die Umsetzung von COz zu CO gemäß dem erfindungsgemäßen Beispiel, bei dem die Mikrowellen mit 50 ns "an" und 25 ns "aus" gepulst waren. Die Y-Achse wurde geteilt, um alle Messwerte in einem Diagramm darstellen zu können. Die linke senkrechte Achse zeigt den prozentualen Gehalt im Bereich von 94 Vol.-% an aufwärts, und die rechte senkrechte Achse den prozentualen Gehalt im Bereich von 3 Vol.-% an abwärts. Die Kurven für den COz-Gehalt im die erfindungsgemäße Vorrichtung verlassenden Produktgas sind der linken senkrechten Achse zugeordnet, d.h. beide Kurven beginnen bei etwas unter 100 Vol.-% Gehalt an COz. Die Kurven für den CO-Gehalt im die erfindungsgemäße Vorrichtung verlassenden Produktgas sind der rechten senkrechten Achse zugeordnet, d.h. beide Kurven beginnen bei etwas über 0 Vol.% Gehalt an CO. Man erkennt sofort, dass nach einen anfänglichen "Einfahren" schon nach etwa 20 Sekunden ein relativ stationärer Zustand erreicht wird und dann eine konstante Umsetzung erzielt wird. Der erreichte Volumenanteil CO im Produktgas liegt bei etwa 2,3 Vol.-%, wenn das Plasma thermisch moduliert wurde und sich ein Sauerstoffüberträger im gleichen Reaktionsraum befand. Wurde das Plasma nicht thermisch moduliert und es befand sich kein Sauerstoffüberträger im gleichen Reaktionsraum, so konnte nur ein Gehalt von 1,1 Vol.-% erreicht werden. Es zeigt sich also aus den Daten deutlich, dass mit dem erfindungsgemäßen Vorgehen erheblich bessere Ausbeuten an CO erhältlich sind.

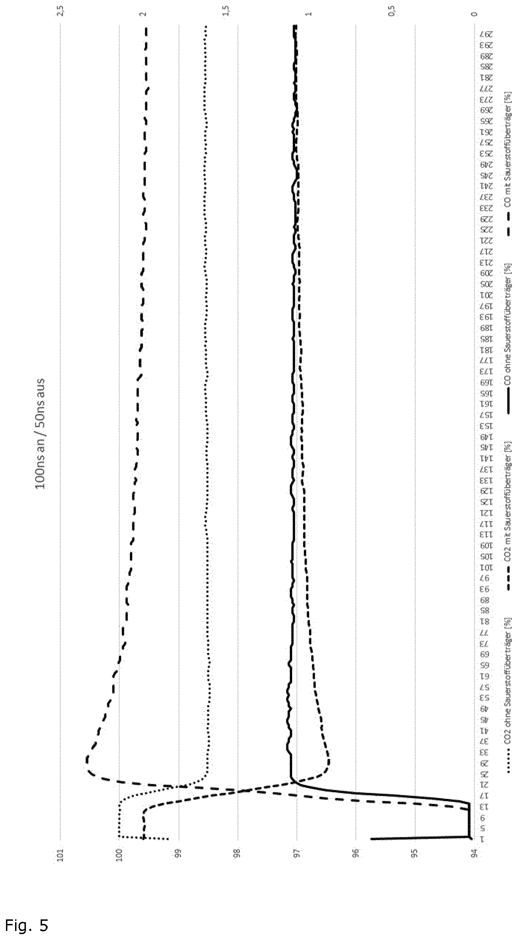

Figur 5 zeigt prinzipiell das Gleiche wie Figur 4, allerdings ist die Pulsdauer hierbei 100 ns "an" und 50 ns "aus". Der erreichte Volumenanteil CO im Produktgas wenn das Plasma thermisch moduliert wurde und sich ein Sauerstoffüberträger im gleichen Reaktionsraum befand beträgt etwas weniger als in Figur 4 und liegt bei etwa 2 Vol.-%. Wurde das Plasma nicht thermisch moduliert und es befand sich kein Sauerstoffüberträger im gleichen Reaktionsraum, so konnte nur ein Gehalt von etwa 1,1 Vol.-% erreicht werden.

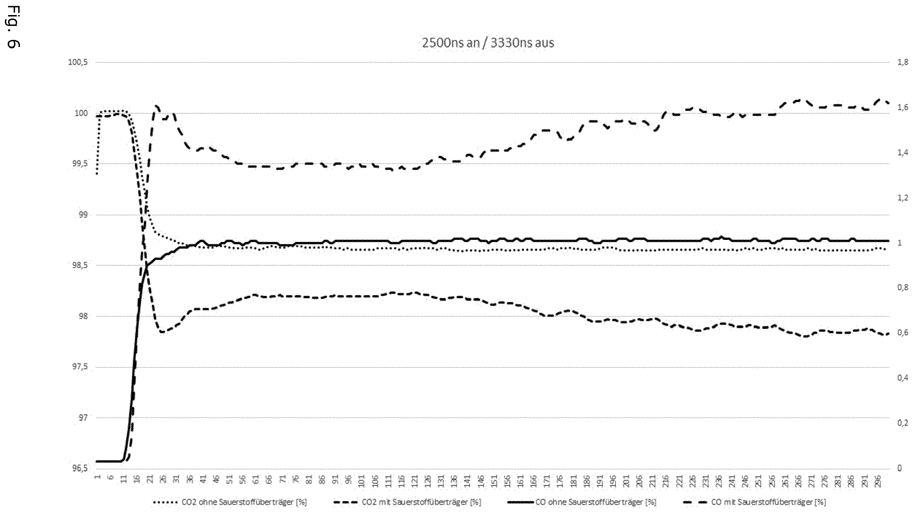

Figur 6 zeigt prinzipiell das Gleiche wie die Figuren 4 und 5, allerdings ist die Pulsdauer hierbei 2500 ns "an" und 3330 ns "aus". Auffällig ist hierbei, dass die Umsetzung nicht so stetig verläuft, wie bei den anderen Umsetzungen. Zudem wird nur etwas mehr als 1,6 Vol.-% CO im Produktgas erreicht, wenn das Plasma thermisch moduliert wurde und sich ein Sauerstoffüberträger im gleichen Reaktionsraum befand. Wurde das Plasma nicht thermisch moduliert und es befand sich kein Sauerstoffüberträger im gleichen Reaktionsraum, so konnte nur ein Gehalt von etwa 1,1 Vol.-% erreicht werden.

Der erreichte Volumenanteil an CO im Produktgas ist also abhängig von den Mikrowellenpulsen.

Bezugszeichenliste:

1     Glasröhre
2     Plasmaerzeugungsvorrichtung
3     Sauerstoffüberträger
4     Reaktionsraum
5     Mikrowellenerzeugungsvorrichtung
6     Unterabschnitt Reaktionsraum
7a    Unterabschnitt Reaktionsraum
7b    Unterabschnitt Reaktionsraum
8     Mikrowellenpulse

Beispiele:

Die Erfindung wird nun unter Bezugnahme auf die folgenden, nicht-limitierenden Beispiele weiter erläutert.

Beispiel: Herstellung von Kohlenmonoxid aus Kohlendioxid.

Ein Sauerstoffüberträgermaterial wurde hergestellt durch Verdichten von ca. 300 mg Cerdioxid (CeOz) durch Pressen mit 30 kN für 3 Minuten. Die so erhaltenen Pellets wurden bei 1.600°C für 5 Stunden gesintert. Danach wurden sie in einen Reduktionsofen eingetragen, mit einer Mischung aus 5% Wasserstoff (in Argon) bei 1.100°C während 3 Stunden reduziert. Die Pellets hatten folgende (durchschnittliche) Dimensionen: 6,80 mm Durchmesser, 2,00 mm Dicke und etwa 380,00 mg Masse.

Als Mikrowellenquelle wurde ein Festkörpergenerator von HBH Microwaves GmbH, Deutschland, mit einer maximalen Ausgangsleistung von 300 Watt und einer Betriebsfrequenz zwischen 2,4 und 2,5 Gigahertz verwendet. Als Plasmareaktor wurde eine industrielle Plasmalanze, Typ PS-CLE von Heuermann HF-Technik GmbH verwendet.

In dem Experiment war die Lanze durch eine Quarzröhre (Glasrohr) umhüllt, deren innerer Durchmesser von 26 mm viel größer war als die Quergröße der Plasmafahne. Zur Messung von Konzentrationen und Reaktionsprodukten wurde ein Emmerson X-Stream XEGP Gasanalysator verwendet. Zur Untersuchung wurde den Konzentrationen von Kohlenmonoxid, Sauerstoff und Kohlendioxid gefolgt. Der Gasanalysator wurde vor jeder Versuchsdurchführung mit Standardkalibrierungsgasen kalibriert und gab die Konzentrationen der Gase in Volumenprozent aus.

Die Rate der $CO_2$-Umsetzung ist ein normalisierter Unterschied von molaren Volumina von COz beim Einfluss und beim Ausfluss:

$$X\_CO2 = (1-CO2\_Ausfluss)/CO2\_Einfluss \qquad [Gleichung\ 1]$$

Die Energie-Brennstoff-Effizienz basiert auf der Sonnenlicht-zu-Brennstoff-Effizienz und wird ausgerückt als:

$$Eta = ((X\_CO2*CO2\_Einfluss)* H\_CO)/P\_absorbiert \qquad [Gleichung\ 2],$$

worin Eta die Energie-zu-Brennstoff-Effizienz ist, H_CO die Verbrennungswärme von Kohlenmonoxid und P_absorbiert die durch das Plasma absorbierte Leistung ist.

Die Experimente bei Umgebungsdruck mit dem Plasma wurden mit reinem $CO_2$-Gasfluss von 12 Standardlitern/Minute (SLM) durchgeführt und mit 200 Watt kontinuierlicher Wellenleistung bei einer Frequenz von 2,45 Gigahertz. Die Gasflussarten werden mit Vögtlin Massenflusskontroller (red-y smart meter GSC, 0,5% Genauigkeit) gesteuert. Das Eduktgas wurde mit einer Temperatur von etwa 20°C zugeführt. Die Temperatur des Plasmas lag in einem Bereich von etwa 400°C bis etwa 1800°C. Das Produktgas am Ende des Reaktors hatte Temperaturen im Bereich von etwa 2900°C bis etwa 400°C.

Das Experiment war in mehrere Teile aufgeteilt. Es wurde die Plasma-Entladung alleine untersucht und die absorbierte Mikrowellenenergie bestimmt. Für $CO_2$-Umsetzung und Effizienz, worin die Konzentration der Produkte mit dem Gasanalysierer gemessen wurde. Ferner wurde ein Pellet des Trägermaterials in Kontakt mit der Entladung gefunden und das Experiment wiederholt.

Tabelle 2 zeigt Messwerte für ein Beispiel der Erfindung betreffend die Herstellung von Kohlenmonoxid aus Kohlendioxid. Durch das schnelle Auffangen von Sauerstoff an dem Sauerstoffüberträger wurde das Verfahren verglichen mit dem Stand der Technik erheblich verbessert.

Der Umsatz und die Effizienz konnten nach 20 Sekunden deutlich verbessert werden mit Umsätzen und Effizienzen von bis zu 4-fach höher. Auf der anderen Seite lief der Prozess nach 5 Minuten immer noch mit Verbesserungen, die fast doppelt so hoch sind, wie in dem Nur-Plasma-Prozess gemäß Stand der Technik.

Die kompletten Messdaten für die Zeit von Beginn des Experiments bis 5 Minuten, also 300 Sekunden (=300 Messpunkte) sind auch in den Figuren 4 bis 6 aufgetragen; jeweils für andere Pulsdauern, also an/aus Status der Mikrowellenerzeugungsvorrichtung.

Die folgende Tabelle zeigt eine vergleichende Aufstellung des Einsatzes von Cerdioxid-Pellets in drei verschiedenen Technologien des Standes der Technik und gemäß der vorliegenden Erfindung zur Umsetzung von COz zu CO; wobei die Umsetzung in einem konventionellen Ofen, ein anderes Mal mittels Solarenergie, weiterhin mittels eines konventionellen Mikrowellenverfahrens und schließlich mit dem erfindungsgemäßen Verfahren mit thermisch moduliertem Plasma (TMP) erfolgt. Wie man sieht, wird bei der erfindungsgemäßen Vorgehensweise eine sehr viel geringere Menge Cerdioxid benötigt und die Zeit bis zum konstanten Reaktionsverlauf ist sehr viel geringer als bei den Verfahren des Standes der Technik. Man erkennt aus der Tabelle sofort, dass man mit der erfindungsgemäßen Vorgehensweise viel schneller eine konstante Produkterzielung erreichen kann, als gemäß Stand der Technik.

Tabelle 1: Vergleich der Erwärmungsdynamiken für verschiedene Technologien

| Technologie | Masse Cerdioxid-Pellet [g] | Zeitkonstante [s] | Spezifische Zeitkonstante [s/g] |
|---|---|---|---|
| Konventionell (Ofen); 390 mbar | 1,158 | 1080 | 932.642487 |

(fortgesetzt)

| Technologie | Masse Cerdioxid-Pellet [g] | Zeitkonstante [s] | Spezifische Zeitkonstante [s/g] |
|---|---|---|---|
| Solar; 10 mbar | 1728 | 200 | 0,115740741 |
| Mikrowelle; 1 atm | 2,4 | 120 | 50 |
| TMP; 1 atm | 0,3 | 6 | 20 |

Tabelle 2: Herstellung von CO ausgehend von COz unter Verwendung von mikrowellenmoduliertem Plasma (TMP) und Sauerstoffüberträger

| Pulsdauer | | Plasma nach 20 Sekunden | Plasma mit Sauerstoffü berträger nach 20 Sekunden | Plasma nach 5 Minuten | Plasma mit Sauerstoffü berträger nach 5 Minuten |
|---|---|---|---|---|---|
| 50ns an / 25ns aus | CO-Menge [ml/min] | 64,8 | 284,4 | 136,8 | 270 |
| | Effizienz [%] | 14,0 | 61,4 | 29,5 | 58,6 |
| 100ns an / 50ns aus | CO-Menge [ml/min] | 118,8 | 204,0 | 130,8 | 237,6 |
| | Effizienz [%] | 20,9 | 35,8 | 23,0 | 41,7 |
| 2500ns an / 3330ns aus | CO-Menge [ml/min] | 108 | 151,2 | 121,2 | 194,4 |
| | Effizienz [%] | 22,7 | 31,8 | 25,5 | 40,9 |

Es zeigt sich aus den Daten (siehe Figuren 4 bis 6) deutlich, dass mit dem erfindungsgemäßen Vorgehen erheblich bessere Ausbeuten an CO erhältlich sind. Zudem ist ersichtlich, dass der erreichte Volumenanteil an CO im Produktgas abhängig von den Mikrowellenpulsen ist.

**Patentansprüche**

1. Verfahren zur Umsetzung von Gasen oder Gasgemischen bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, umfassend die folgenden Schritte oder bestehend aus diesen:

A) Zuführen eines Gases oder Gasgemisches, insbesondere umfassend entweder Sauerstoff, Stickstoff oder Wasserstoff und/oder eine eines dieser Elemente enthaltende Verbindung, oder Kohlendioxid-haltiges Gas mit einem COz-Gehalt von mindestens 40 Vol.-%, bevorzugt mindestens 50 Vol.-%, besonders bevorzugt mindestens 75 Vol.-%, insbesondere mindestens 95 Vol.-%, des umzusetzenden Gases oder Gasgemisches, in eine Plasmaerzeugungsvorrichtung;
B) Einleiten des in der Plasmaerzeugungsvorrichtung erzeugten Plasmas in einen Reaktionsraum umfassend einen Feststoff-Überträger für Sauerstoff oder Stickstoff oder Wasserstoff oder Kohlendioxid;
C) Umsetzen des Plasmas am Feststoff-Überträger, wobei das jeweilige Gas an den Feststoff-Überträger gebunden und dieser oxidiert, nitriert, hydriert oder karbonatisiert wird;
D) Ableiten des Produktgases bzw. Produktgasgemisches aus dem Reaktionsraum;

E) optional Regenerieren des Feststoff-Übertragers für Sauerstoff, Stickstoff, Wasserstoff oder Kohlendioxid durch Überleiten eines mit dem in C) erhaltenen Feststoff-Überträger in einem Plasma reagierenden, von dem in A) eingesetzten Gas oder Gasgemisch unterschiedlichen Gases oder Gasgemisches, und Umsetzen dieses Gases oder Gasgemisches am Feststoff-Überträger, wodurch letzterer wieder in den Ausgangszustand versetzt wird und entweder gebundener Sauerstoff, Stickstoff, Wasserstoff oder gebundenes Kohlendioxid von dem Feststoff-Überträger freigesetzt wird und mit dem übergeleiteten Gas oder Gasgemisch reagiert;

wobei ein thermisch moduliertes Plasma gemäß einer der folgenden Varianten

1) Leistungsmodulation durch pulsierenden Energieeintrag in die Plasmaerzeugungseinrichtung;
2) pulsierende Zuführung der Gase oder Reaktanten in die Plasmaerzeugungseinrichtung mit Pulsdauern im Bereich von Nanosekunden bis Sekunden;
3) Pulsationen des Volumenstroms in der Plasmaerzeugungseinrichtung, im Reaktionsraum oder nach dem Träger mit Frequenzen, die die Gastemperatur dazu bringen mit einer Rate von höher als $10^3$ K/s zu fallen;
4) Kühlen nach der Plasmaerzeugung mit Wärmetauschern oder Volumenstrommanagement;
5) intermittierende Expansion der Reaktionsmischung auf Drücke von >1 bar;
6) Abtrennung von wenigstens einem der Reaktanten;
7) durch Wechselwirkung des Reaktionssystems mit anderen Materialien oder Verbindungen; oder
8) durch intermittierende Wechselwirkung des Gas-Stroms mit externer Energie;

erzeugt wird,
der Feststoff-Überträger für Sauerstoff, Stickstoff, Wasserstoff oder Kohlendioxid durch das gebildete Plasma erwärmt wird und optional zusätzlich durch Pulse von Mikrowellenenergie erwärmt wird, und wobei die Pulsdauer, Pulsfrequenz und die abgegebene Leistung der von der Mikrowellenerzeugungsvorrichtung erzeugten Mikrowellenenergie, zur Einstellung eines gewünschten Energieeintrages in Plasma und Feststoff-Überträger für Sauerstoff, Stickstoff, Wasserstoff oder Kohlendioxid, voreingestellt und/oder gesteuert werden.

2. Verfahren nach Anspruch 1, **dadurch gekennzeichnet, dass** das Plasma durch Pulse von Mikrowellenenergie gebildet und erwärmt wird.

3. Verfahren nach Anspruch 1 oder 2, **dadurch gekennzeichnet, dass** beide Schritte C) und E) durchgeführt werden und bevorzugt dabei im Hinblick auf den Feststoff-Überträger für Sauerstoff, Stickstoff, Wasserstoff oder Kohlendioxid ein Reaktions-/Regenerationszyklus (Chemical Looping) darstellen.

4. Verfahren nach einem der Ansprüche 1 bis 3, **dadurch gekennzeichnet, dass** das erzeugte Plasma einen Energiegehalt von mindestens 1 eV bis höchstens 10 eV hat.

5. Verfahren nach einem der Ansprüche 1 bis 4, **dadurch gekennzeichnet, dass**

- das Gasgemisch in Schritt A) COz und das Gasgemisch in Schritt E) Methan und Wasserstoff umfasst, oder
- als Gasgemisch in Schritt A) Luft oder stickstoffangereicherte Luft eingesetzt wird und in Schritt E) ein Gasgemisch umfassend Wasserdampf werden; oder
- als Gasgemisch in Schritt A) Luft oder stickstoffangereicherte Luft eingesetzt wird und das Gasgemisch in Schritt E) Alkane, insbesondere C1 bis C4-n-Alkane, umfasst.

6. Vorrichtung, bevorzugt zur Durchführung eines Verfahrens gemäß einem der Ansprüche 1 bis 5, insbesondere zur Durchführung von Chemical-Looping-Prozessen, umfassend

I) mindestens eine Zuleitungsvorrichtung für ein Gas oder Gasgemisch, konfiguriert das Gas oder Gasgemisch in eine Plasmaerzeugungsvorrichtung zu leiten,
II) eine Plasmaerzeugungsvorrichtung, konfiguriert, aus dem zugeführten Gas oder Gasgemisch, ein Plasma bei einem Druck von 5 bis 3000 kPa, bevorzugt 10 bis 100 kPa, besonders bevorzugt Umgebungsdruck plus/minus 10 kPa, insbesondere Umgebungsdruck plus/minus 1 kPa, zu erzeugen und in einen Reaktionsraum einzuleiten,
III) einem Reaktionsraum umfassend einen Feststoff, der als Überträger entweder für Sauerstoff oder Stickstoff oder Wasserstoff oder Kohlenstoffdioxid fungiert,
IV) Plasmamodulationseinrichtung, konfiguriert ein thermisch moduliertes Plasma gemäß einer der folgenden Varianten

1) Leistungsmodulation durch pulsierenden Energieeintrag in die Plasmaerzeugungseinrichtung;

2) pulsierende Zuführung der Gase oder Reaktanten in die Plasmaerzeugungseinrichtung mit Pulsdauern im Bereich von Nanosekunden bis Sekunden;

3) Pulsationen des Volumenstroms in der Plasmaerzeugungseinrichtung, im Reaktionsraum oder nach dem Träger mit Frequenzen, die die Gastemperatur dazu bringen mit einer Rate von höher als $10^3$ K/s zu fallen;

4) Kühlen nach der Plasmaerzeugung mit Wärmetauschern oder Volumenstrommanagement;

5) intermittierende Expansion der Reaktionsmischung auf Drücke von >1 bar;

6) Abtrennung von wenigstens einem der Reaktanten;

7) durch Wechselwirkung des Reaktionssystems mit anderen Materialien oder Verbindungen; oder

8) durch intermittierende Wechselwirkung des Gas-Stroms mit externer Energie,

zu erzeugen,

V) mindestens eine Ableitungsvorrichtung für Produktgas oder Produktgasgemisch, die stromabwärts des Reaktionsraumes angeordnet ist,

wobei die Pulsdauer, Pulsfrequenz und die abgegebene Leistung von der Plasmamodulationseinrichtung zur Einstellung eines gewünschten Energieeintrages in Plasma und gegebenenfalls Feststoff-Überträger, voreinstellbar oder steuerbar ist.

7. Vorrichtung nach Anspruch 6, **dadurch gekennzeichnet, dass** als Plasmamodulationseinrichtung

IV) eine Energieerzeugungsvorrichtung oder Mikrowellenerzeugungsvorrichtung, konfiguriert, die von ihr erzeugte Energie oder Mikrowellenenergie gepulst in das in die Plasmaerzeugungsvorrichtung eingeführte Gas oder Gasgemisch einzutragen und gegebenenfalls zusätzlich auf den als Überträger entweder für Sauerstoff oder Stickstoff oder Wasserstoff oder Kohlenstoffdioxid fungierenden Feststoff einwirken zu lassen, und bevorzugt konfiguriert, ein Plasma mit einem Energiegehalt von mindestens 1 eV zu erzeugen,

eingesetzt wird, wobei die Pulsdauer, Pulsfrequenz und die abgegebene Leistung der von der Mikrowellenerzeugungsvorrichtung erzeugten Mikrowellenenergie zur Einstellung eines gewünschten Energieeintrages in Plasma und gegebenenfalls Feststoff-Überträger, voreinstellbar oder steuerbar ist.

8. Vorrichtung nach Anspruch 6 oder 7, **dadurch gekennzeichnet, dass** das Material für den Feststoff-Überträger für Sauerstoff, Stickstoff, Wasserstoff oder Kohlendioxid ausgewählt ist aus Metall, Keramik, oder Metall-Keramik-Verbundwerkstoffen, bevorzugt auf Basis von Metallen ausgewählt aus Metallen aus der Gruppe bestehend aus Ba, Ca, Mg, Al, Ga, Sn, Cu, Zn, La, Mo, Sr, W, Ti, Zr, V, Ce, Cr, Mn, U, Fe, Co, Ni und Kombinationen davon, besonders bevorzugt auf Basis von, insbesondere aus, Zirkoniumdioxid, Cerdioxid, Calciumoxid, Aluminiumoxid, Magnesium-Aluminat und Mischungen davon, insbesondere Cerdioxid oder Calciumoxid.

9. Vorrichtung nach Anspruch 6 bis 8, **dadurch gekennzeichnet, dass** der Feststoff-Überträger für Sauerstoff, Stickstoff, Wasserstoff oder Kohlendioxid als Schüttung, Wanderbett oder Wirbelbett auf Basis von Partikeln oder Pellets, als strukturierte Packung, beispielsweise Extrudat, Schaum oder additiv gefertigte Struktur, oder als Beschichtung oder Mischungen davon, optional auf einem Träger oder zwischen Rückhaltevorrichtungen immobilisiert, bevorzugt als Wirbelbett oder additiv gefertigte Struktur, vorliegt.

10. Vorrichtung nach einem der Ansprüche 6 bis 9, konfiguriert, die Mikrowellenenergie mit einem Pulsverhältnis eingeschaltet:ausgeschaltet von zwischen 1:1 und 3:1, bevorzugt 1,5:1 und 2,5:1, besonders bevorzugt bei 2:1, in das Plasma einzutragen.

11. Vorrichtung nach einem der Ansprüche 6 bis 10, konfiguriert, die Mikrowellenenergie mit einer eingeschalteten Dauer pro Puls von zwischen 20 ns und 100 ns, bevorzugt 30 ns bis 70 ns, besonders bevorzugt 50 ns, einzutragen.

12. Vorrichtung nach einem der Ansprüche 6 bis 11, **dadurch gekennzeichnet, dass** sie zusätzlich umfasst

VI) eine Vorrichtung zur Einleitung eines reduzierenden Gases oder Gasgemisches in den Reaktionsraum, wobei die Vorrichtung so konfiguriert ist, dass bei Einleitung des reduzierenden Gases oder Gasgemisches die Plasmaerzeugungsvorrichtung, und optional auch die Mikrowellenerzeugungsvorrichtung, inaktiv ist.

13. Verwendung des Verfahrens gemäß einem der Ansprüche 1 bis 5 oder der Vorrichtung gemäß einem der Ansprüche 6 bis 12 zur Herstellung

- von Olefinen mittels partieller Oxidation von Alkanen,
- von Ammoniak aus Luft und Wasser, oder
- von Kohlenmonoxid aus Kohlendioxid,

bevorzugt von Ammoniak aus Luft und Wasser, oder von Kohlenmonoxid aus Kohlendioxid, insbesondere von Kohlenmonoxid aus Kohlendioxid.

14. Verwendung des Verfahrens gemäß einem der Ansprüche 1 bis 5 oder der Vorrichtung gemäß einem der Ansprüche 6 bis 12 zur

- zur Herstellung chemischer Energieträger ausgehend von mittels erneuerbarer Energien zur Verfügung gestelltem Strom, insbesondere CO, $H_2$, Ammoniak, Olefine oder den oxidierten, nitrierten, hydrierten oder karbonatisierten Feststoff-Überträger für Sauerstoff, Stickstoff, Wasserstoff oder Kohlendioxid
- in oder gekoppelt mit Fischer-Tropsch-Anlagen, bevorzugt zur Herstellung von CO, $H_2$ oder Synthesegas, insbesondere gekoppelt mit Anlagen zur Fischer-Tropsch-Synthese oder Methanolsynthese.

15. Verwendung des Verfahrens gemäß einem der Ansprüche 1 bis 5 oder der Vorrichtung gemäß einem der Ansprüche 6 bis 12 zur Umsetzung von Strom, bevorzugt Stromspitzen, besonders bevorzugt überschüssigem Strom, insbesondere durch erneuerbare Energietechnik erzeugten überschüssigem Strom, in speicherbare Energie in Form chemischer Verbindungen.

Fig. 1

**Oxidation Sauerstoffüberträger**
- Erwärmen mittels thermisch moduliertem Plasma und Aktivieren des Sauerstoffüberträgermaterials
- Bildung von reduzierten Produkten oder Intermediaten

Oxidans + M → reduziertes Produkt + MO

thermisch moduliertes Plasma + Sauerstoffüberträger

Reduktans + MO → oxidiertes Produkt + M

**Reduzierung Sauerstoffüberträger**
- Erwärmen mittels thermisch moduliertem Plasma und Aktivieren des Sauerstoffüberträgermaterials
- Kontaktieren mit einem energetischen Reaktanten
- Bildung von oxidierten Produkten oder Intermediaten

EP 4 258 321 A1

Fig. 2a

Fig. 2b

Fig.3

Fig. 4

EP 4 258 321 A1

50ns an / 25 ns aus

······ CO2 ohne Sauerstoffüberträger [%]   ─ ─ ─ CO2 mit Sauerstoffüberträger [%]   ─── CO ohne Sauerstoffüberträger [%]   ─ ─ CO mit Sauerstoffüberträger [%]

Fig. 5

Fig. 6

Europäisches
Patentamt

European
Patent Office

Office européen
des brevets

**EUROPÄISCHER RECHERCHENBERICHT**

Nummer der Anmeldung

EP 23 16 6989

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | CN 112 403 416 A (UNIV SHANDONG) 26. Februar 2021 (2021-02-26) | 1,5,6,8, 9,13-15 | INV. H01J37/32 B01J19/00 |
| Y | * Abbildung 1 * | 2,4,7, | |
| | * Zusammenfassung * | 10,11 | |
| A | * Absatz [0001] – Absatz [0004] * | 3,12 | |
| | * Ansprüche 1-10 * | | |
| | ----- | | |
| Y | SOLDATOV S. ET AL: "Efficiency of a compact CO2 coaxial plasma torch driven by ultrafast microwave power pulsing: Stability and plasma gas flow dynamics", JOURNAL OF CO2 UTILIZATION, Bd. 58, 2. Februar 2022 (2022-02-02), Seite 101916, XP093074918, NL ISSN: 2212-9820, DOI: 10.1016/j.jcou.2022.101916 * 1. Introduction, und 2. Experimental methods * | 2,4,7, 10,11 | |
| | ----- | | |
| A | DE 10 2020 116950 A1 (GRAFORCE GMBH [DE]) 30. Dezember 2021 (2021-12-30) * das ganze Dokument * | 1-15 | **RECHERCHIERTE SACHGEBIETE (IPC)** |
| | ----- | | H01J |
| A | US 2020/215515 A1 (LI FANXING [US] ET AL) 9. Juli 2020 (2020-07-09) * das ganze Dokument * | 1-15 | B01J |
| | ----- | | |
| A | WO 2008/134871 A1 (PRINCIPLE ENERGY SOLUTIONS INC [CA]; EASTMAN CRAIG D [CA] ET AL.) 13. November 2008 (2008-11-13) * das ganze Dokument * | 1-15 | |
| | ----- | | |

Der vorliegende Recherchenbericht wurde für alle Patentansprüche erstellt

| Recherchenort | Abschlußdatum der Recherche | Prüfer |
|---|---|---|
| Den Haag | 21. August 2023 | Hochstrasser, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...........................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 16 6989

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-08-2023

| Im Recherchenbericht angeführtes Patentdokument | Datum der Veröffentlichung | Mitglied(er) der Patentfamilie | Datum der Veröffentlichung |
|---|---|---|---|
| CN 112403416      A | 26-02-2021 | KEINE | |
| DE 102020116950 A1 | 30-12-2021 | CN      115720532 A | 28-02-2023 |
| | | DE 102020116950 A1 | 30-12-2021 |
| | | EP        3980176 A1 | 13-04-2022 |
| | | JP     2023533469 A | 03-08-2023 |
| | | KR    20230029925 A | 03-03-2023 |
| | | WO     2021260027 A1 | 30-12-2021 |
| US 2020215515      A1 | 09-07-2020 | US     2020215515 A1 | 09-07-2020 |
| | | US     2021213424 A1 | 15-07-2021 |
| | | WO     2018232133 A1 | 20-12-2018 |
| WO 2008134871      A1 | 13-11-2008 | AU     2008247280 A1 | 13-11-2008 |
| | | CA        2685609 A1 | 13-11-2008 |
| | | CN      101849036 A | 29-09-2010 |
| | | EP        2150637 A1 | 10-02-2010 |
| | | JP     2010526214 A | 29-07-2010 |
| | | KR    20100031500 A | 22-03-2010 |
| | | US     2008283411 A1 | 20-11-2008 |
| | | US     2012329657 A1 | 27-12-2012 |
| | | US     2016194766 A1 | 07-07-2016 |
| | | WO     2008134871 A1 | 13-11-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20200255290 A1
- US 9580326 B1
- US 20160194766 A1
- WO 2020174118 A1
- US 20150030529 A1
- US 9399575 B2
- US 20150215515 A1

**In der Beschreibung aufgeführte Nicht-Patentliteratur**

- **SOLDATOV, SERGEY et al.** Time-resolved optical emission spectroscopy reveals nonequilibrium conditions for CO2 splitting in atmospheric plasma sustained with ultrafast microwave pulsation. *ACS Energy Letters,* 2020, vol. 6.1, 124-130